# EUROPEAN PATENT APPLICATION

(11) **EP 4 580 361 A1**
(43) Date of publication of application: **02.07.2025**
(21) Application number: 24196887.4
(22) Date of filing: 28.08.2024
(51) Int. Cl.: H10K 59/121

(54) **TRANSPARENT DISPLAY APPARATUS**

(30) Priority: 27.12.2023 KR 20230193039
(71) Applicant: LG Display Co., Ltd., Seoul 07336 (KR)
(72) Inventor: Song, JiHun, 10845 Paju-si (KR); Kwon, Hoiyong, 10845 Paju-si (KR); Kim, Youngwan, 10845 Paju-si (KR)
(74) Representative: Cousens, Nico

(57) **Abstract**

A transparent display apparatus in one example can include a substrate having a display area in which a plurality of pixels are disposed and a non-display area adjacent to the display area. The plurality of pixels have a transmissive portion and a plurality of sub-pixels. The transparent display apparatus can further include a plurality of dam areas extending from the non-display area to the display area on the substrate and provided to be a closed loop.

## Description

### CROSS-REFERENCE TO RELATED APPLICATIONS

This application claims priority to Korean Patent Application No. 10-2023-0193039, filed in the Republic of Korea on December 27, 2023.

### BACKGROUND

### Field

The present disclosure relates to a transparent display apparatus.

### Discussion of the Related Art

With the advancement of the information age, the demand for a display apparatus capable of displaying an image has increased in various forms. As such, various types of display apparatuses such as a liquid crystal display (LCD) device, a plasma display panel (PDP) device, an organic light emitting display (OLED) device and a quantum dot light emitting display (OLED) device have been used.

Recently, studies for a transparent display apparatus in which a user can view objects or background positioned at an opposite side by transmitting the display apparatus are actively ongoing.

These transparent display apparatuses have the potential to be utilized in a wide variety of fields because they can be viewed both as an image display and as a background, but due to the wide variety of applications and uses, they need to be manufactured in various types (or various sizes). However, when the transparent display apparatuses are manufactured in multiple varieties (or different sizes), the number of processes can increase, resulting in the increasing manufacturing costs and production energy

### SUMMARY OF THE DISCLOSURE

An aspect of the present disclosure is directed to providing a transparent display apparatus that can be manufactured in various types (or various sizes) in an effective manner.

Further, an aspect of the present disclosure is directed to providing a transparent display apparatus in which production energy can be reduced.

Further, an aspect of the present disclosure is directed to providing a transparent display apparatus that can be manufactured in various types (or various sizes) and still have reduced or prevented moisture permeation.

The problems to be solved by the examples of the present disclosure are not limited to those mentioned above, and other problems not mentioned and other limitations associated with the related art, which are to be addressed by the examples of the present disclosure, will be apparent to one of ordinary skill in the art.

A transparent display apparatus according to an embodiment of the present disclosure can include a substrate having a display area in which a plurality of pixels are disposed and a non-display area around the display area, the plurality of pixels having a transmissive portion and a plurality of sub-pixels; and a plurality of dam areas extending from the non-display area to the display area on the substrate and provided to be a closed loop.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a schematic plan view of a transparent display apparatus according to one embodiment of the present disclosure.
FIG. 2 is an enlarged plan view of portion A shown in FIG. 1.
FIG. 3 is a schematic cross-sectional view of line I-I' shown in FIG. 2.
FIG. 4 is a schematic cross-sectional view of an example of portion C shown in FIG. 3.
FIG. 5 is a schematic cross-sectional view illustrating another example of portion C shown in FIG. 3.
FIG. 6 is a schematic cross-sectional view of line II - II' shown in FIG. 2.
FIG 7 is a schematic plan view of another example of FIG 2.
FIG. 8 is a schematic plan view of another example of FIG. 2.
FIG. 9 is a schematic cross-sectional view of line III-III' shown in FIG. 8.
FIG. 10 is an enlarged plan view of portion B shown in FIG. 1.
FIG. 11 is a schematic cross-sectional view of line IV-IV' shown in FIG. 10.
FIG. 12 is a schematic cross-sectional view of a transparent display apparatus according to a second embodiment of the present disclosure.
FIG. 13 is a schematic cross-sectional view of a transparent display apparatus according to a third embodiment of the present disclosure.
FIG. 14 is a schematic cross-sectional view of a transparent display apparatus according to a fourth embodiment of the present disclosure.
FIG. 15 is a schematic cross-sectional view of FIG. 14.
FIG. 16 is a schematic cross-sectional view illustrating a portion of a transparent display apparatus according to a fifth embodiment of the present disclosure.
FIG. 17 is a schematic cross-sectional view of line V-V' shown in FIG. 16.

### DETAILED DESCRIPTION OF THE EMBODIMENTS

Reference will now be made in detail to the embodiments of the present disclosure, examples of which are illustrated in the accompanying drawings. Wherever possible, the same reference numbers will be used throughout the drawings to refer to the same or like parts.

Advantages and features of the present disclosure, and implementation methods thereof will be clarified through following embodiments described with reference to the accompanying drawings. The present disclosure may, however, be embodied in different forms and should not be construed as limited to the embodiments set forth herein. Rather, these embodiments are provided so that this disclosure will be thorough and complete, and will fully convey the scope of the present disclosure to those skilled in the art.

A shape, a size, a ratio, an angle, and a number disclosed in the drawings for describing embodiments of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In a case where 'comprise', 'have', and 'include' described in the present disclosure are used, another part can be added unless 'only' is used. The terms of a singular form can include plural forms unless referred to the contrary.

In construing an element, the element is construed as including an error range although there is no explicit description.

In describing a position relationship, for example, when a position relation between two parts is described as 'on', 'over', 'under', and 'next', one or more other parts can be disposed between the two parts unless 'just' or 'direct' is used.

In describing a temporal relationship, for example, when the temporal order is described as "after," "subsequent," "next," and "before," a case which is not continuous can be included, unless "just" or "direct" is used.

It will be understood that, although the terms "first," "second," etc. can be used herein to describe various elements, these elements should not be limited by these terms. These terms are only used to distinguish one element from another, and may not define order or sequence. For example, a first element could be termed a second element, and, similarly, a second element could be termed a first element, without departing from the scope of the present disclosure.

Further, "X-axis direction", "Y-axis direction" and "I-axis direction" should not be construed by a geometric relation only of a mutual vertical relation and can have broader directionality within the range that elements of the present disclosure can act functionally.

The term "at least one" should be understood as including any and all combinations of one or more of the associated listed items. For example, the meaning of "at least one of a first item, a second item and a third item" denotes the combination of all items proposed from two or more of the first item, the second item and the third item as well as the first item, the second item or the third item.

Features of various embodiments of the present disclosure can be partially or overall coupled to or combined with each other and can be variously inter-operated with each other and driven technically as those skilled in the art can sufficiently understand. The embodiments of the present disclosure can be carried out independently from each other or can be carried out together in co-dependent relationship. Further, the term "can" fully encompasses all the meanings and coverages of the term "may."

Hereinafter, the various embodiments of the present disclosure will be described in detail with reference to the accompanying drawings. All the components of each transparent display apparatus according to all embodiments of the present disclosure are operatively coupled and configured.

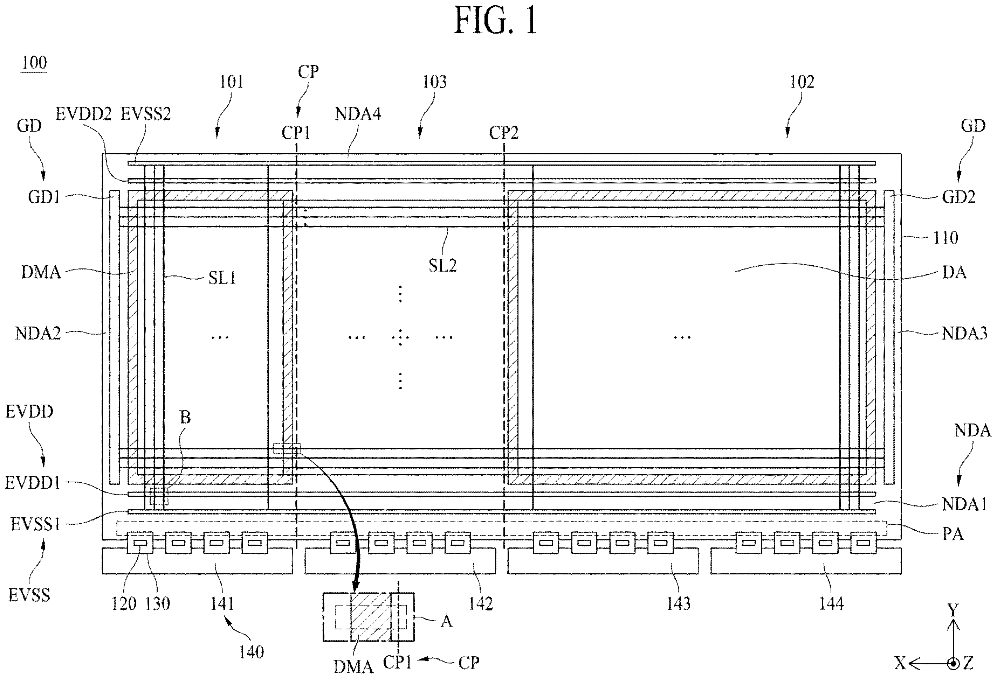

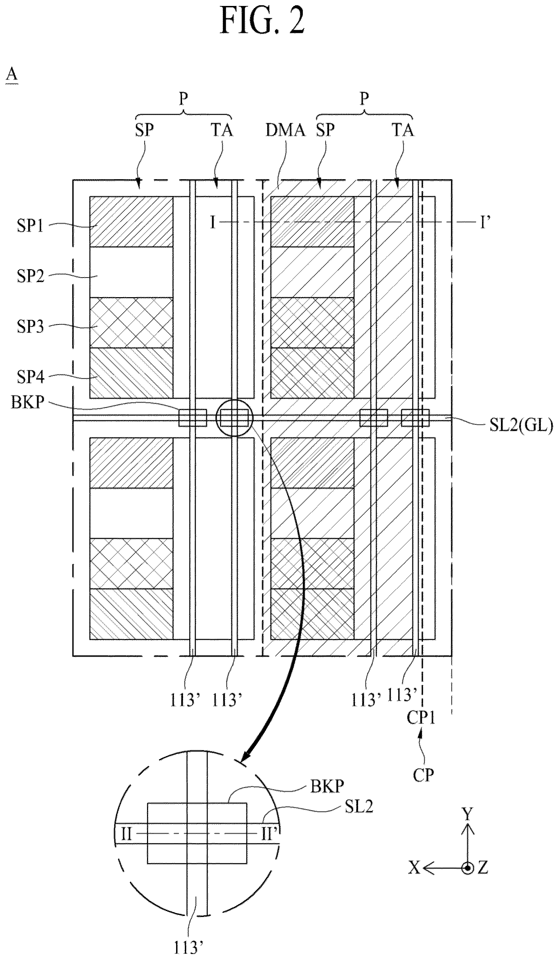

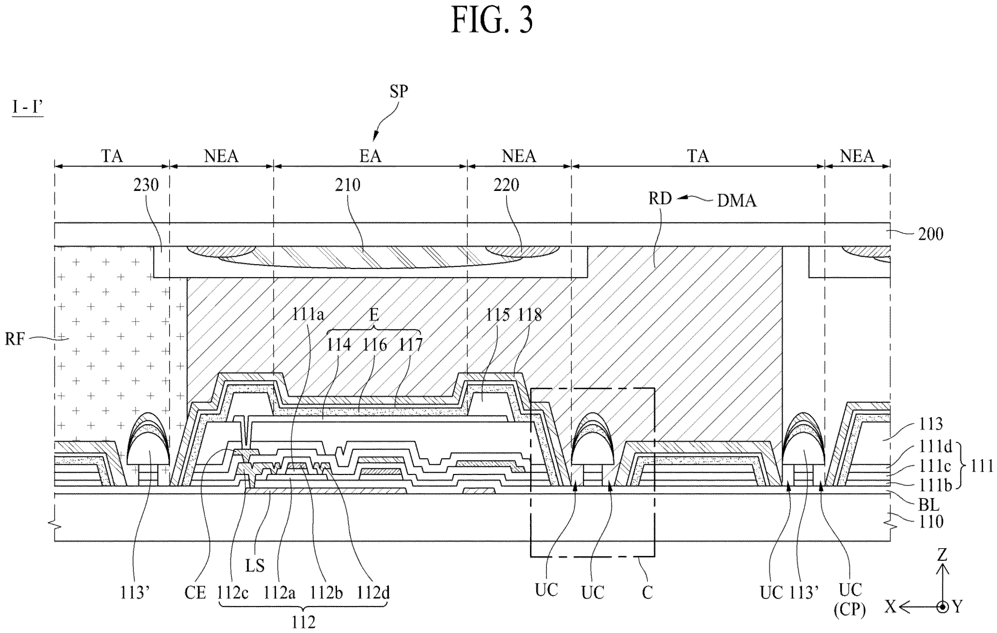

FIG. 1 is a schematic plan view of a transparent display apparatus according to one embodiment of the present disclosure, FIG. 2 is an enlarged plan view of portion A shown in FIG. 1, and FIG. 3 is a schematic cross-sectional view of line I-I' shown in FIG. 2.

Hereinafter, a Y-axis direction indicates a direction in parallel to a first line SL1 (e.g., the data line) (e.g., a first direction), a X-axis direction indicates a direction in parallel to a second line SL2 (e.g., the gate line) (e.g., a second direction), and a Z-axis direction indicates a thickness direction of the transparent display apparatus 100 (e.g., a third direction).

Referring now to FIG. 1 to FIG. 3, a transparent display apparatus 100 according to one embodiment of the present disclosure includes a substrate 110 having a display area DA and a non-display area NDA (or bezel area) and a plurality of dam areas DMAs. The plurality of dam areas DMAs are provided on the substrate 110 and extending from the non-display area NDA (or bezel area) to the display area DA in a closed loop. The display area DA includes a plurality of pixels P having a transmissive portion TA and a plurality of sub-pixels SP, respectively, and the non-display area NDA is around the display area DA. Each of the plurality of dam areas DMAs according to one example can be provided as a closed loop.

Here, each of the plurality of dam areas DMA being provided as a closed loop can mean that the display area DA is partially surrounded by the dam areas DMA, as shown in FIG. 1. Thus, the display area DA can be surrounded by the plurality of dam areas DMA having a closed structure, and can have a structure that is divided by the plurality of dam areas DMA. For example, as shown in FIG. 1, the transparent display apparatus 100 according to one embodiment of the present disclosure can include two dam areas DMA, and can include two display areas DAs having different areas (or sizes) by each of the dam areas DMA. Thus, the transparent display apparatus 100 according to one embodiment of the present disclosure can be divided into two transparent display apparatuses having different areas (or sizes) when a cut is made between two dam areas DMAs. For example, the transparent display apparatus 100 according to one embodiment of the present disclosure can be divided into a first transparent display apparatus 101 having a first area, and a second transparent display apparatus 102 having a second area larger than the first area.

Thus, the transparent display apparatus 100 according to one embodiment of the present disclosure can be manufactured in various types (or various sizes) by being provided with the plurality of dam areas DMAs such that the display panels can be cut into different sizes. However, the transparent display apparatus 100 according to one embodiment of the present disclosure can also be implemented as a single transparent display apparatus if it is not divided by a cutting device. Thus, as shown in FIG. 1, when including two dam areas DMAs, the transparent display apparatus 100 according to one embodiment of the present disclosure can be implemented as a first transparent display apparatus 101 having a first area, a second transparent display apparatus 102 having a second area larger than the first area, and a third transparent display apparatus 103 having a third area smaller than the second area. The display panel can include the substrate 110 and an opposing substrate 200 bonded to face the substrate 110.

Accordingly, in the transparent display apparatus 100 according to one embodiment of the present disclosure, production energy can be reduced compared to a transparent display apparatus produced in various types (or various sizes) through different production processes (or manufacturing processes).

On the other hand, even if the transparent display apparatus 100 according to one embodiment of the present disclosure is divided into the first and second transparent display apparatuses 101, 102, moisture permeation can be reduced or prevented because the dam area DMA covers the edges of each of the first and second transparent display apparatuses 101, 102 in a closed-loop structure (or closed structure). Thus, even though the transparent display apparatus 100 according to one embodiment of the present disclosure is cut (or divided) into a plurality of transparent display apparatuses, the reliability of each of the plurality of transparent display apparatuses against moisture permeation can be improved.

Hereinafter, with reference to FIGS. 1 to 3, a transparent display apparatus 100 according to one embodiment of the present disclosure will be described in more detail.

Referring to FIG. 1, a transparent display apparatus 100 according to one embodiment of the present disclosure can include a source drive integrated circuit (hereinafter IC) 120, a flexible film 130, and a plurality of circuit boards 140, and a display panel including a substrate 110 having the plurality of gate drivers GDs. The plurality of circuit boards 140 can be connected to a timing controller via cables.

The display panel can include a substrate 110 and an opposite substrate 200 (shown in FIG. 3).

The substrate 110 can include a thin film transistor, and can be a transistor array substrate, a lower substrate, a base substrate, or a first substrate. The substrate 110 can be a transparent glass substrate or a transparent plastic substrate. For example, the substrate 110 can be a transparent glass substrate. Hereinafter, the substrate 110 will be defined as a first substrate.

The opposing substrate 200 can be facing and bonded to the first substrate 110 via a connection member RD (shown in FIG. 3) and a filling member RF (shown in FIG. 3). For example, the opposing substrate 200 can have a smaller size than the first substrate 110 and can be facing and bonded to a portion of the first substrate 110 except the pad portion. The opposing substrate 200 can be an upper substrate, a second substrate, or an envelope substrate. The opposing substrate 200 can be bonded to the first side of the first substrate 110 by a substrate bonding process mediated by an adhesive member. Hereinafter, the opposing substrate 200 is defined as the second substrate.

The transparent display apparatus 100 according to one embodiment of the present disclosure can further comprise the connection member RD and the filling member RF.

The dam area DMA, according to one example, can include the connecting member RD. The connection member RD can be disposed between the first substrate 110 and the second substrate 200. Accordingly, the first substrate 110 and the second substrate 200 can be facing and bonded to each other via the connection member RD. For example, the connection member RD can comprise a thermosetting transparent adhesive or a light-curable transparent adhesive. The connecting member RD can include an absorbent material (not shown) for absorbing external moisture or humidity that permeate to the display area DA.

The connecting members RD of the dam area DMA, according to one example, can be disposed in the non-display area NDA and extending from the non-display area NDA to the display area DA. As shown in FIG. 3, the connection member RD can be disposed to fill a gap between the first substrate 110 and the second substrate 200 in the dam area DMA. Accordingly, the connecting member RD can prevent moisture or the like from permeating to the display area DA through the gap between the first substrate 110 and the second substrate 200.

The filling member RF can be disposed adjacent to the connecting member RD. The filling member RF can be disposed to fill a gap between the first substrate 110 and the second substrate 200, thereby supporting the first substrate 110 and the second substrate 200. Thus, the filling member RF can prevent the first substrate 110 and the second substrate 200 from being easily deformed by an external force.

On the other hand, the filling member RF or the connecting member RD can be disposed between an organic light-emitting layer 116 formed on the first substrate 110 and the second substrate 200 to prevent external moisture or humidity permeating through the second substrate 200 from reaching the organic light-emitting layer 116. In other words, each of the filling member RF and the connecting member RD can have a barrier function to prevent moisture permeation. Each of the filling member RF and the connecting member RD can further include an absorbent material to absorb water or moisture to increase the moisture barrier effect. For example, the absorbent material can be a getter.

On the other hand, the filling member RF can comprise a thermosetting transparent adhesive or a light-curable transparent adhesive. In this case, the filling member RF can be utilized to bond the first substrate 110 and the second substrate 200 together with the connection member RD. Thus, the bonding force of the first substrate 110 and the second substrate 200 can be further improved. Since each of the plurality of dam areas DMA partially surrounds the display area DA, the filling member RF can be disposed to be surrounded by the connecting member RD. The connection members RD can overlap the plurality of pixels P by being partially disposed in the display area DA.

The connecting member RD according to one example can comprise an opaque material but is not necessarily limited thereto and can comprise a transparent material. The filling member RF according to one example is disposed in the display area DA, so it can comprise a transparent material to improve the transmittance of the light emitted.

Referring again to FIG. 1, the gate driver GD supplies gate signals to the gate lines in accordance with the gate control signal input from the timing controller. When the source drive IC 120 is manufactured as a driving chip, the source drive IC 120 can be packaged in the flexible film 130 in a chip on film (COF) method or a chip on plastic (COP) method.

Pads, such as power pads, data pads, can be formed in the non-display area of the display panel. Lines connecting the pads with the source drive IC 120 and lines connecting the pads with lines of the circuit board 140 can be formed in the flexible film 130. The flexible film 130 can be attached onto the pads by using an anisotropic conducting film, whereby the pads can be connected with the lines of the flexible film 130.

The first substrate 110 according to an example can include a display area DA and a non-display area NDA.

The display area DA is an area where an image is displayed, and can be a pixel array area, an active area, a pixel array unit, a display unit, or a screen. For example, the display area DA can be disposed at a central portion of the display panel (or the first substrate 110).

The display area DA according to an example can include gate lines, data lines, pixel driving power lines, and a plurality of pixels P. Each of the plurality of pixels P can include a plurality of sub-pixels SP and the transmissive portion TA (shown in FIG. 2). The plurality of sub-pixels SP can be defined by the gate lines and the data lines. The transmissive portion TA is disposed adjacent to the plurality of sub-pixels SP. The transmissive portion TA is an area configured to allow light to transmit through the front and back sides of the display panel. Thus, a user positioned at the front side of the display panel can view an image, background, or the like positioned at the back side of the display panel through the transmissive portion TA.

Referring to FIG. 2, each of the plurality of sub-pixels SP can be defined as an area of the smallest unit in which actual light is emitted.

According to one example, at least four sub-pixels SP disposed adjacent to each other among the plurality of sub-pixels SP, and one transmissive portion TA constitute one unit pixel P. The one unit pixel can include a red sub-pixel, a green sub-pixel, a blue sub-pixel, a white sub-pixel, and the transmissive portion TA, but is not limited to. In one example, the one unit pixel can comprise at least one red sub-pixel, at least one green sub-pixel, at least one blue sub-pixel, at least one white sub-pixel, and at least one transmissive portion TA.

In another example, three sub-pixels SPs disposed adjacent to each other among the plurality of sub-pixels SPs, and one transmissive portion TA constitute one unit pixel. The one unit pixel can include, but is not limited to, at least one red sub-pixel, at least one green sub-pixel, at least one blue sub-pixel, and one transmissive portion TA.

Each of the plurality of sub-pixels SPs can include a thin film transistor, and a light emitting portion connected to the thin film transistor. The light emitting portion can include a light emitting element layer (or the organic emitting layer) interposed between the anode electrode (or first electrode) and the cathode electrode (or second electrode).

The light emitting element layers respectively disposed in the plurality of subpixels SP can individually emit light of their respective colors different from one another or commonly emit white light. According to an example, when the light emitting element layers of the plurality of subpixels SP commonly emit white light, each of the red subpixel, the green subpixel and the blue subpixel can include a color filter (or wavelength conversion member) for converting white light into light of its respective different color. In this case, the white subpixel according to an example may not include a color filter. In the transparent display apparatus 100 according to one embodiment of the present disclosure, the red sub-pixel can be a first sub-pixel SP1, the white sub-pixel can be a second sub-pixel SP2, the green sub-pixel can be a third sub-pixel SP3, and the blue sub-pixel can be a fourth sub-pixel SP4.

Each of the subpixels SP supplies a predetermined current to the organic light emitting element in accordance with a data voltage of the data line when a gate signal is input from the gate line by using the thin film transistor. For this reason, the light emitting portion of each of the subpixels can emit light with a predetermined brightness in accordance with the predetermined current. A structure of each of the subpixels SP will be described later with reference to FIG. 3.

The non-display area NDA can be an area where an image is not displayed, and can be a peripheral circuit area, a signal supply area, a non-active area, or a bezel area. The non-display area NDA can be configured to be around the display area DA. For example, the non-display area NDA can be disposed to surround the display area DA.

The transparent display apparatus 100, according to one embodiment of the present disclosure, can include the plurality of gate drivers GDs disposed in the non-display area NDA. As shown in FIG. 1, the plurality of gate driver GDs can be disposed in the first direction (Y-axis direction) in the non-display area NDA. The plurality of gate drivers GDs can be disposed in parallel to each other interposed with the display area DA therebetween, but are not necessarily limited thereto.

Each of the plurality of gate drivers GDs supplies gate signals to the gate lines according to gate control signals input from the timing controller connected to the plurality of circuit boards 140. Each of the plurality of gate drivers GDs can be formed in a gate driver in panel GIP manner in the non-display area NDA on either outer side of the display area DA, as shown in FIG. 1. Alternatively, the plurality of gate drivers GD can be made of a driving chip, mounted on a flexible film, and attached to the non-display areas NDA on both outer sides of the display area DA of the display panel by a TAB (tape automated bonding) method. The gate driver GD according to one example can include a plurality of gate driver circuits (or GIP circuits) and a plurality of GIP wiring. The GIP wiring, in one example, can include a plurality of signal wiring and a plurality of power wiring.

The plurality of gate drivers GDs can be disposed separately on the left side of the display area DA, i.e., the second non-display area NDA2, and on the right side of the display area DA, i.e., the third non-display area NDA3. According to one example, a plurality of gate drivers GD can be connected to the plurality of pixels P and the plurality of wiring (or a plurality of second lines SL2) for supplying power and/or signals to each of the plurality of pixels P. As shown in FIG. 1, the transparent display apparatus 100 according to one embodiment of the present disclosure can further include a plurality of first lines SL1 intersecting with the plurality of second lines SL2.

The plurality of second lines SL2 can extend in a second direction (X-axis direction). Each of the plurality of second lines SL2 can include at least one gate line GL (or scan line GL). The second direction (X-axis direction) can refer to a direction in parallel to the gate line GL.

In the following, when the second line SL2 comprises a plurality of lines, one second line SL2 can refer to a group of signal lines comprising a plurality of lines. For example, when the second line SL2 includes two scan lines, one second line SL2 can refer to a group of signal lines comprising two scan lines.

The plurality of first lines SL1 can extend in the first direction (Y-axis direction). The plurality of first lines SL1 can intersect with the plurality of second lines SL2. Each of the plurality of first lines SL1 can be connected to at least one of a plurality of pads, a pixel power shorting bar or pixel power line EVDD, and a common power shorting bar EVSS disposed in a first non-display area NDA1. The pixel power supply shorting bar EVDD and the common power supply shorting bar EVSS can be disposed in the first non-display area NDA1 disposed between the pad area PA and the display area DA with respect to the display area DA, and in a fourth non-display area NDA4 disposed to face the pad area PA. The first direction (X-axis direction) can be a direction in parallel to the data line.

The pixel-powered shorting bar EVDD can include a first pixel-powered shorting bar EVDD1 disposed in the first non-display area NDA1, and a second pixel-powered shorting bar EVDD2 disposed in the fourth non-display area NDA4. The first pixel power shorting bar EVDD1 and the second pixel power shorting bar EVDD2 can be disposed in parallel to the second direction (X-axis direction) with the display area DA interposed therebetween.

The common power supply shorting bar EVSS can include a first common power supply shorting bar EVSS1 disposed in the first non-display area NDA1, and a second common power supply shorting bar EVSS2 disposed in the fourth non-display area NDA4. The first common power supply shorting bar EVSS1 and the second common power supply shorting bar EVSS2 can be disposed in parallel to the second direction (X-axis direction) with the display area DA interposed therebetween. According to an example, the first common power supply shorting bar EVSS1 and the second common power supply shorting bar EVSS2 can be disposed closer to the edge of the first substrate 110 than the first pixel power supply shorting bar EVDD1 and the second pixel power supply shorting bar EVDD2.

The plurality of first lines SL1 can include a pixel power line connected to the pixel power shorting bar EVDD and a common power line connected to the common power shorting bar EVSS. In one embodiment, the plurality of first lines SL1 can further include a plurality of data lines and reference lines.

Hereinafter, when the first line SL1 includes a plurality of lines, one first line SL1 can refer to a signal line group consisting of a plurality of lines. For example, when the first line SL1 includes two data lines, the pixel power line, the common power line, and the reference line, one first line SL1 can refer to a group of signal lines comprising two data lines, the pixel power line, the common power line, and the reference line.

The pixels P are disposed to overlap with at least one of the first line SL1 and the second line SL2, and emit a predetermined light to display an image. The light emission area EA can correspond to an area in which the pixels P emit light.

Referring to FIG. 2, each of the pixels P can include a first sub-pixel SP1, a second sub-pixel SP2, a third sub-pixel SP3, and a fourth sub-pixel SP4. The first sub-pixel SP1 can be configured to include a first light emission area EA emitting red light, the second sub-pixel SP2 can be configured to include a second light emission area emitting white light, the third sub-pixel SP3 can be configured to include a third light emission area emitting green light, and the fourth sub-pixel SP4 can be configured to include a fourth light emission area emitting blue light. In FIG. 2, the first to fourth sub-pixels SP1, SP2, SP3, SP4 included in the one pixel P are illustrated as being disposed in the first direction (Y-axis direction), but the arrangement order of each of the sub-pixels SP1, SP2, SP3, SP4 can be varied.

Since the transparent display apparatus 100 according to one embodiment of the present disclosure is configured that the light emitting element emits white light, thus the second sub-pixel SP2, which is a white sub-pixel as shown in FIG. 2, may not be provided with a color filter. On the other hand, the first sub-pixel SP1 can be provided with a red color filter 210 thus red light is emitted, the third sub-pixel SP3 can be provided with a green color filter so that green light is emitted, and the fourth sub-pixel SP4 can be provided with a blue color filter so that blue light is emitted.

Hereinafter, with reference to FIGS. 2 and 3, the pixel P of a transparent display apparatus 100 according to one embodiment of the present disclosure will be described.

Referring to FIGS. 2 and 3, each of the plurality of pixels P provided in the display area DA can include the plurality of sub-pixels SP and the transmissive portion TA. The transmissive portion TA can be disposed adjacent to each of the plurality of sub-pixels SP, as shown in FIG. 2. As shown in FIG. 3, the connection member RD can be disposed in the sub-pixels SP disposed in the dam area DMA. Further, the filling member RF can be disposed in the sub-pixels SP disposed in the display area DA other than the dam area DMA. However, as shown in FIG. 3, both the filling member RF and the connecting member RD may not be disposed in the area where the cutting portion CP is disposed. Since the transparent display apparatus 100 according to one embodiment of the present disclosure is provided so that both the filling member RF and the connecting member RD are not formed in the cutting portion CP. Therefore, the transparent display apparatus 100 according to one embodiment of the present disclosure not only can the manufacturing cost be reduced due to material savings, but also the defect rate can be reduced since the area in which the filling member RF and the connecting member RD are not disposed is cut, and thus cutting can be facilitated. In FIG. 3, the connecting member RD can be disposed in a sub-pixel SP disposed in the dam area DMA, and the filling member RF can be disposed in the sub-pixel SP disposed in a display area DA rather than the dam area DMA. However, as shown in FIG. 3, both the filling element RF and the connecting element RD may not be disposed in the area where the cutting portion CP is disposed. By not forming both the filling member RF and the connecting member RD in the cutting portion CP, not only manufacturing costs can be reduced due to material savings, but also the defect rate can be reduced because the area in which the filling member RF and the connecting member RD are not disposed is cut, thereby facilitating cutting.

On the other hand, since the structure of the sub-pixel SP in which the filling member RF is disposed is identical the structure of the sub-pixel SP in which the connecting member RD is disposed, as shown in FIG. 3, the description of the sub-pixel SP in which the filling member RF is disposed is substituted by the description of the sub-pixel SP in which the connecting member RD is disposed.

Referring again to FIG. 3, each of the plurality of sub-pixels SPs can be disposed on the first substrate 110 and can include a buffer layer BL to prevent moisture permeation to the thin film transistors 112.

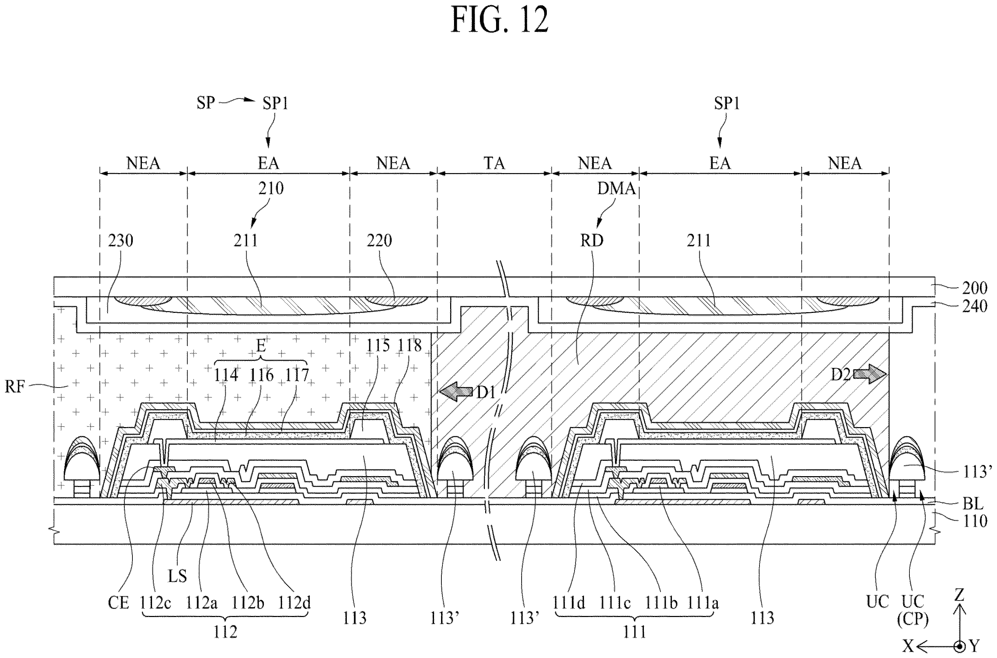

Further, each of the sub-pixels SPs according to one embodiment of the present disclosure comprises an inorganic layer 111, a planarization layer 113 provided on the inorganic layer 111, an anode electrode 114 (or first electrode 114) provided on the planarization layer 113, a bank 115, the organic emitting layer 116, a cathode electrode 117 (or second electrode 117), and an encapsulation layer 118. The inorganic layer 111 is provided on an upper surface of the buffer layer BL and includes a gate insulating layer 111a (see FIG.12), an interlayer insulating layer 111b, a first passivation layer 111c, and a second passivation layer 111d.

The inorganic layer 111 can be disposed with thin-film transistors 112 for driving the sub-pixels SP. The inorganic layer 111 can also be expressed in terms of a circuit element layer. A buffer layer BL can be included in the inorganic layer 111 along with the gate insulating layer 111a, the interlayer insulating layer 111b, the first passivation layer 111c, and the second passivation layer 111d. The anode electrode 114, the organic emitting layer 116, and the cathode electrode 117 can be included in the light emitting element.

The buffer layer BL can be formed between the first substrate 110 and the gate insulating layer 111a to protect the thin film transistor 112. Between the buffer layer BL and the first substrate 110, a pixel power line EVDD or a wiring electrically connected to the pixel power line EVDD can be disposed. The buffer layer BL can be disposed entirely on one surface (or front surface) of the first substrate 110. The buffer layer BL can serve to prevent a material contained in the first substrate 110 from being diffused into a transistor layer during a high temperature process of the manufacturing process of the thin film transistor. Optionally, the buffer layer BL can be omitted as the case can be.

The thin film transistor 112 according to an example can include an active layer 112a, a gate electrode 112b, a source electrode 112c, and a drain electrode 112d.

The active layer 112a can include a channel area, a drain area and a source area, which are formed in a thin film transistor area of a circuit area of the pixel P. The drain area and the source area can be spaced apart from each other with the channel area interposed therebetween.

The active layer 112a can be formed of a semiconductor material based on any one of amorphous silicon, polycrystalline silicon, oxide and organic material.

The gate insulating layer 111a can be formed on the channel area of the active layer 112a. As an example, the gate insulating layer 111a can be formed in an island shape only on the channel area of the active layer 112a, or can be formed on an entire front surface of the first substrate 110 or the buffer layer BL, which includes the active layer 112a.

The gate electrode 112b can be formed on the gate insulating layer 111a to overlap the channel area of the active layer 112a.

The interlayer insulating layer 111b can be formed on the gate electrode 112b and the drain area and the source area of the active layer 112a. The interlayer insulating layer 111b can be formed in the circuit area and an entire light emission area, in which light is emitted to the pixel P. For example, the interlayer insulating layer 111b can be made of an inorganic material, but is not necessarily limited thereto.

The source electrode 112c can be electrically connected to the source area of the active layer 112a through a source contact hole provided in the interlayer insulating layer 111b overlapped with the source area of the active layer 112a. Further, the source electrode 112c can be connected to the wiring LS electrically connected to the pixel power line EVDD through contact holes provided in the interlayer insulating layer 111b and the buffer layer BL that do not overlap with the source area of the active layer 112a. The source electrode 112c can be connected to the anode electrode 114 via a connection electrode CE penetrating the first passivation layer 111c.

The drain electrode 112d can be electrically connected to the drain area of the active layer 112a through a drain contact hole provided in the interlayer insulating layer 111b overlapped with the drain area of the active layer 112a.

The drain electrode 112d and the source electrode 112c can be made of the same metal material. For example, each of the drain electrode 112d and the source electrode 112c can be made of a single metal layer, a single layer of an alloy or a multilayer of two or more layers, which is the same as or different from that of the gate electrode.

In addition, the circuit area can further include first and second switching thin film transistors disposed together with the thin film transistor 112, and a capacitor. Since each of the first and second switching thin film transistors is provided on the circuit area of the pixel P to have the same structure as that of the thin film transistor 112, its description will be omitted. The capacitor can be provided in an overlap area between the gate electrode 112b and the source electrode 112c of the thin film transistor 112, which overlap each other with the interlayer insulating layer 111b interposed therebetween.

Additionally, in order to prevent a threshold voltage of the thin film transistor provided in a pixel area from being shifted by light, the display panel or the first substrate 110 can further include a light shielding layer (not shown) provided below the active layer 112a of at least one of the thin film transistor 112, the first switching thin film transistor and the second switching thin film transistor. The light shielding layer can be disposed between the first substrate 110 and the active layer 112a to shield light incident on the active layer 112a through the first substrate 110, thereby minimizing a change in the threshold voltage of the transistor due to external light.

The first passivation layer 111c can be disposed between the first substrate 110 and the planarization layer 113. The first passivation layer 111c, according to one example, covers a drain electrode 112d and the source electrode 112c of the thin film transistor 112 and the interlayer insulating layer 111b. The first passivation layer 111c can be formed throughout the circuit area and the light emission area.

The second passivation layer 111d can be provided on the first substrate 110 to cover the pixel (or the light emission area EA). For example, the second passivation layer 111d can be provided to cover the connection electrode CE between the first passivation layer 111c and the planarization layer 113. The second passivation layer 111d can be formed throughout the circuit area and the light emission area.

The planarization layer 113 can be provided on the first substrate 110 to cover the second passivation layer 111d. When the second passivation layer 111d is omitted, the planarization layer 113 can be provided on the first substrate 110 to cover the circuit area. The planarization layer 113 can be formed throughout the circuit area and the light emission area. Further, the planarization layer 113 can be formed throughout the display area DA and the non-display area NDA except for the pad area PA. For example, the planarization layer 113 can include an extension (or extensions) extending from the display area DA toward the rest of the non-display area NDA except for the pad area PA. Thus, the planarization layer 113 can have a relatively larger size than the display area DA.

The planarization layer 113 according to an example can be formed to be relatively thick, and thus can provide a flat surface on the display area DA and the non-display area NDA. For example, the planarization layer 113 can be made of an organic material such as photo acryl, benzocyclobutene, polyimide, and fluorine resin.

The anode electrodes 114 of the sub-pixels SP can be formed on the planarization layer 113. The anode electrode 114 is connected to the source electrode or the drain electrode of the thin film transistor 112 by being connected to the connection electrode CE through the contact hole through the planarization layer 113 and the second passivation layer 111d.

The anode electrode 114 can be made of at least one of a transparent metal material, a semi-transmissive metal material, and a metal material having high reflectance.

When the transparent display apparatus 100 is provided in a top emission mode, the anode electrode 114 can be formed of a metal material having high reflectance or a stacked structure of a metal material having high reflectance and a transparent metal material. For example, the anode electrode 114 can be formed of a metal material having high reflectance, such as a stacked structure (Ti/Al/Ti) of aluminum and titanium, a stacked structure (ITO/AI/ITO) of aluminum and ITO, an Ag alloy, and a stacked structure (ITO/Ag alloy/ITO) of Ag alloy and ITO. The Ag alloy can be an alloy such as silver (Ag), palladium (Pd), and copper (Cu).

When the transparent display apparatus 100 is provided in a bottom emission mode, the anode electrode 114 can be formed of a transparent conductive material (TCO) such as ITO and IZO, which can transmit light, or a semi-transmissive conductive material such as magnesium (Mg), silver (Ag) or an alloy of magnesium (Mg) and silver (Ag).

Meanwhile, the material constituting the anode electrode 114 can include MoTi. The anode electrode 114 can be a first electrode or a pixel electrode.

The bank 115 is a non-light emission area in which light is not emitted, and can be provided to surround each of light emission areas of the plurality of subpixels SP. For example, the bank 115 can partition (or define) the respective light emission areas EA.

The bank 115 can be formed on the planarization layer 113 to cover an edge of the anode electrode 114, thereby partitioning (or defining) the light emission areas EA (or light emitting portions) of the plurality of subpixels SP.

The bank 115 can be formed to cover an edge of each of the anode electrodes 114 included in each of the sub-pixels SPs and to expose a portion of each of the anode electrodes 114. Accordingly, the bank 115 can cover an end of each of the anode electrodes 114, thereby preventing shorting of the anode electrodes 114 and the cathode electrodes 117. The exposed portion of the anode electrode 114 that is not covered by the bank 115 can be the light emission area EA (or the light emitting portion).

The bank 115 can be formed of an organic layer such as an acrylic resin, an epoxy resin, a phenolic resin, a polyamide resin, and a polyimide resin, but is not limited thereto.

The organic emitting layer 116 is formed on the anode electrode 114 and the bank 115. When a voltage is applied to the anode electrode 114 and the cathode electrode 117, holes and electrons migrate to the organic emitting layer 116, respectively, and they combine with each other in the organic emitting layer 116 to emit light.

The organic light emitting layer 116 can be formed of a plurality of subpixels SP and a common layer provided on the bank 115. In this case, the organic light emitting layer 116 can be provided in a tandem structure in which a plurality of light emitting layers, for example, a yellow-green light emitting layer and a blue light emitting layer are stacked, and can emit white light when an electric field is formed between the anode electrode 114 and the cathode electrode 117.

A color filter 210 suitable for a color of a corresponding subpixel SP can be formed on the second substrate 200. For example, a red color filter can be provided in a red subpixel SP1, a green color filter can be provided in a green subpixel, and a blue color filter can be provided in a blue subpixel. A white subpixel may not include a color filter because the organic light emitting layer 116 emits white light.

The cathode electrode 117 is formed on the organic light emitting layer 116. The cathode electrode 117 can be a common layer commonly formed in the subpixels SP. The cathode electrode 117 can be made of a transparent metal material, a semi-transmissive metal material or a metal material having high reflectance.

When the transparent display apparatus 100 is provided in a top emission mode, the cathode electrode 117 can be formed of a transparent conductive material (TCO) such as ITO and IZO, which can transmit light, or a semi-transmissive conductive material such as magnesium (Mg), silver (Ag) or an alloy of magnesium (Mg) and silver (Ag).

When the transparent display apparatus 100 is provided in a bottom emission mode, the cathode electrode 117 can be formed of a metal material having high reflectance, such as a stacked structure (Ti/AI/Ti) of aluminum and titanium, a stacked structure (ITO/AI/ITO) of aluminum and ITO, an Ag alloy and a stacked structure (ITO/Ag alloy/ITO) of Ag alloy and ITO. The Ag alloy can be an alloy of silver (Ag), palladium (Pd), copper (Cu), etc. The cathode electrode 117 can be a second electrode or an opposing electrode.

The encapsulation layer 118 is formed on the cathode electrode 117. The encapsulation layer 118 serves to prevent oxygen or water from being permeated into the organic light emitting layer 116 and the cathode electrode 117. To this end, the encapsulation layer 118 can include at least one organic layer and at least one inorganic layer.

In the transparent display apparatus 100 according to one embodiment of the present disclosure, the encapsulation layer 118 can be disposed in the non-display area NDA as well as the display area DA. The encapsulation layer 118, according to one example, can be disposed between the cathode electrode 117 (and/or the buffer layer BL) and the second substrate 200.

Since the encapsulation layer 118 is disposed in the display area DA and extends into the non-display area NDA, the encapsulation layer 118 can contact the dam area DMA in the non-display area NDA (or on the periphery) of the display panel. Furthermore, since the transparent display apparatus 100 according to one embodiment of the present disclosure includes the dam area DMA disposed in the display area DA and extending to a portion of the display area DA, the encapsulation layer 118 can be in contact with the dam area DMA (or the connecting member RD included in the dam area DMA) even in the display area DA.

Thus, the transparent display apparatus 100 according to one embodiment of the present disclosure can be prevented from moisture permeation toward the display area DA, and even if it is divided into a plurality of pieces through the cutting portion CP, moisture permeation toward the display area DA can be effectively prevented.

Referring again to FIG. 3, the color filter 210 and the black matrix 220 can be disposed between the encapsulation layer 118 and the second substrate 200. In one example, the color filter 210 can be disposed correspondingly to each of a plurality of sub-pixels SPs (or a plurality of light emission areas EA) on the second substrate 200 (or the opposing substrate).

As described above, the white sub-pixel, i.e., the second sub-pixel SP2, may not be provided with a color filter since the organic light emitting layer 116 emits white light. On the other hand, the red sub-pixel, i.e., the first sub-pixel SP1, can be provided with the color filter 210 between the encapsulation layer 118 and the second substrate 200.

As shown in FIG. 3, the black matrix 220 can be disposed at the edge of the color filter 210. Thus, the black matrix 220 can prevent color mixing between the sub-pixels SPs. The black matrix 220 can comprise a black-based material and can be disposed in the non-emitting area NEA. In one example, the black matrix 220 can be formed on the second substrate 200 in at least partially overlap the bank 115, thereby reducing the cell gap between the organic light emitting layer 116 and the second substrate 200, thereby preventing mixing between sub-pixels.

The transparent display apparatus 100 according to one embodiment of the present disclosure can further comprise a plurality of upper organic layers 230 covering the color filter 210. As shown in FIG. 3, each of the plurality of upper organic layers 230 can be configured to cover not only the color filter 210, but also the black matrix 220.

In one example, the plurality of upper organic layers 230 can be spaced apart from each other interposed with the permeable portion or transmissive portion TA therebetween. Since the upper organic layer 230 is an organic layer, it can be a moisture permeable path from the outside to the display area DA. However, in the transparent display apparatus 100 according to one embodiment of the present disclosure, the plurality of upper organic layers 230 can be spaced apart from each other, thus the moisture permeation path to the display area DA can be blocked.

Furthermore, the transparent display apparatus 100 according to one embodiment of the present disclosure is configured such that the plurality of upper organic layers 230 are not disposed in the transmissive portion TA, thus the transmittance can be improved as compared to the case where the organic layers are disposed in the transmissive portion TA.

On the other hand, with the plurality of upper organic layers 230 spaced apart from each other interposed the transmissive area or transmissive portion TA therebetween, the connecting member RD (shown in FIG. 3) can be disposed between the plurality of upper organic layers 230. For example, the connecting member RD can be partially disposed between the plurality of upper organic layers 230. In one example, the connecting member RD can be disposed entirely between the plurality of upper organic layers 230 or can be disposed partially between the plurality of upper organic layers 230 as shown in FIG. 3. This is the description of the layout structure in the dam area DMA, and in the display area DA where the dam area DMA is not disposed, the filling member RF can be partially disposed between the plurality of upper organic layers 230.

The transparent display apparatus 100 according to one embodiment of the present disclosure can comprise the plurality of N number (N is an integer greater than 1) dam areas DMAs on the first substrate 110. For example, as shown in FIG. 1, the transparent display apparatus 100 according to one embodiment of the present disclosure can include two dam areas DMAs. Each of the two dam areas DMAs can be configured in a closed loop shape (or closed form) enclosing a different area of the display area DA. However, without limitation, the two DMAs can be configured in a closed loop (or closed form) enclosing the same area of the display area DA.

Each of the plurality of dam areas DMAs can include a first dam disposed in a non-display area NDA, and a second dam disposed extending from the non-display area NDA into a display area DA. As shown in FIG. 1, the first dam and the second dam can be continuous to each other, thereby being provided as a single closed dam area DMA. As shown in FIG. 1, the second dam can be disposed across the display area DA. Thus, the transparent display apparatus 100 according to one embodiment of the present disclosure can have a structural feature in which the dam area DMA overlaps in the third direction (Z-axis direction) with a pixel P (or sub-pixel SP) disposed in the display area DA.

Referring to FIGS. 1 and 2, the transparent display apparatus 100 according to one embodiment of the present disclosure can further comprise the cutting portion CP provided between the N dam areas DMA. The cutting portion CP according to one example can be a portion that is cut by a cutting device such as a laser or a wheel. Thus, when the cutting portion CP is cut by the cutting device, the transparent display apparatus 100 according to one embodiment of the present disclosure can be divided into the first transparent display apparatus 101 and the second transparent display apparatus 102. In FIG. 1, the transparent display apparatus 100 according to one embodiment of the present disclosure is shown configured to be divided into two transparent display apparatuses having different areas (or size), but is not limited to, it can be configured to be divided into two transparent display apparatuses having the same area (or size).

Referring to FIG. 1 as an example, a transparent display apparatus 100 according to one embodiment of the present disclosure can be configured to be divided into a first transparent display apparatus 101 having a first area and a second transparent display apparatus 102 having a second area larger than the first area via a cutting portion CP. The third transparent display apparatus 103 between the first transparent display apparatus 101 and the second transparent display apparatus 102 does not have the gate driver GD capable of driving the display area DA, and thus cannot be utilized in substance as a transparent display apparatus. However, without being limited thereto, if a gate driver GD can be connected to the third transparent display apparatus 103, the third transparent display apparatus 103 can function as a transparent display apparatus.

On the other hand, when the third transparent display apparatus 103 cannot be utilized as a transparent displayapparatus, the filling member RF and the connecting member RD may not be disposed in the area of the third transparent display apparatus 103 located between the first transparent display apparatus 101 and the second transparent display apparatus 102. Accordingly, the transparent display apparatus 100 according to one embodiment of the present disclosure can have a reduced manufacturing cost since the filling member RF and the connecting member RD are not formed in an area that cannot be utilized as a transparent display apparatus, and the defect rate can be reduced since the area in which the filling member RF and the connecting member RD are not disposed can be cut, and cutting can be facilitated.

As a result, the transparent display apparatus 100 according to one embodiment of the present disclosure can be provided with the plurality of dam areas DMA in a number corresponding to the number of the plurality of gate drivers GDs. Consequently, the transparent display apparatus 100 according to one embodiment of the present disclosure can be provided to be divided into the plurality of transparent display apparatuses as many as the number of the plurality of gate drivers GD (or the number of the plurality of dam areas DMA).

Referring again to FIG. 1, in the transparent display apparatus 100 according to one embodiment of the present disclosure, each of the plurality of gate drivers GDs can be disposed in the first direction (Y-axis direction) in the non-display area NDA. Here, the cutting portion CP can be disposed parallel to the gate driver GD. Because when the cutting portion CP is disposed in a direction that crosses the gate driver GD, the gate driver GD is damaged by the cutting device and may not be operated as a transparent display apparatus. Therefore, in the transparent display apparatus 100 according to one embodiment of the present disclosure, the cutting portion CP can be disposed parallel to the gate driver GD. For example, as shown in FIG. 1, the cutting portion CP can be disposed in the first direction (Y-axis direction) between the two gate drivers GD1, GD2. Therefore, the transparent display apparatus 100 according to one embodiment of the present disclosure can be cut in the first direction (Y-axis direction) by the cutting device, accordingly can be configured to be divided into a first transparent display apparatus 101 and a second transparent display apparatus 102 having different areas (or sizes).

As shown in FIG. 1, the cutting portion CP is disposed in a perpendicular direction and can therefore be expressed in terms of a perpendicular cutting line. Alternatively, the cutting portion CP can be expressed in terms of a one way cutting line, as the transparent display apparatus 100 is cut in one direction.

On the other hand, the transparent display apparatus 100 according to one embodiment of the present disclosure can be provided with only one cutting portion CP, but is not limited thereto, and can be provided with two cutting portions CPs, as shown in FIG. 1. For example, the cutting portion CP can include a first cutting portion CP1 disposed between the first transparent display apparatus 101 and the third transparent display apparatus 103, and a second cutting portion CP2 disposed between the third transparent display apparatus 103 and the second transparent display apparatus 102.

When the cutting device cuts the first cutting portion CP1 and the second cutting portion CP2, the one transparent display can be divided into three transparent display units, and the first transparent display 101 with the first gate drive GD1 and the second transparent display unit 102 with the second gate drive GD2 can be utilized as separate transparent display with different areas (or sizes). The third transparent display apparatus 103 disposed between the first cutting portion CP1 and the second cutting portion CP2 does not have a gate driver, and therefore may not function as a transparent display apparatus in substance. However, as described above, when the third transparent display apparatus 103 can be connected with a gate driver, it can also function as a transparent display apparatus.

Referring to FIG. 1, in the transparent display apparatus 100 according to one embodiment of the present disclosure, the circuit board 140 can include a first circuit board 141, a second circuit board 142, a third circuit board 143, and a fourth circuit board 144. For example, the first circuit board 141 can be connected to the first transparent display apparatus 101. The first circuit board 141 can be connected to the timing controller through a cable. The second circuit board 142 can be connected to the third transparent display apparatus 103. As described above, the second circuit board 142 may not be connected to the timing controller unit when the third transparent display apparatus 103 is not capable of functioning as a transparent display apparatus. The third circuit board 143 and the fourth circuit board 144 can be connected to the second transparent display apparatus 102. The third circuit board 143 and the fourth circuit board 144 can be connected to the timing controller through a cable. Thus, when the transparent display apparatus 100 according to one embodiment of the present disclosure is separated (or divided) by the cutting device, the first transparent display apparatus 101 and the second transparent display apparatus 102 can function as respective transparent display apparatuses having different areas (or sizes).

The transparent display apparatus 100 according to one embodiment of the present disclosure can include the planarization layer 113 disposed on the first substrate 110, and a plurality of inorganic layers 111 disposed between the first substrate 110 and the planarization layer 113. For example, the plurality of inorganic layers 111 can be the gate insulating layer 111a, the interlayer insulating layer 111b, the first passivation layer 111c, and the second passivation layer 111d disposed on the upper surface of the buffer layer BL.

The transparent display apparatus 100, according to one embodiment of the present disclosure, can include an undercut portion UC from which the planarization layer 113 and the plurality of inorganic layers 111 have been partially removed.

The undercut portion UC according to one example can be formed by partially removing each of the interlayer insulating layer 111b, the first passivation layer 111c, and the second passivation layer 111d. As shown in FIG. 3, the undercut portion UC can be formed in the transmissive portion TA, for example, the transmissive portion TA can include the undercut portion UC.

The undercut portion UC is for disconnecting the organic light emitting layer 116 provided in the transmissive portion TA. Since in the transparent display apparatus 100 according to one embodiment of the present disclosure, the organic light emitting layer 116, the cathode electrode 117, and the encapsulation layer 118 is formed after the undercut portion UC is formed, the organic light emitting layer 116 can be disconnected by the undercut portion UC. Thus, the transparent display apparatus 100 according to one embodiment of the present disclosure can be prevented from moisture permeation through the organic light emitting layer 116.

The undercut portion UC according to one example can be provided with M numbers (M is an integer greater than 0) in the transmissive portion TA. Since the undercut portion UC is an area where the organic light-emitting layer 116 is discontinuous, moisture permeation to the display area DA can be prevented even if the undercut portion UC is cut by a cutting device. Therefore, in the transparent display apparatus 100 according to one embodiment of the present disclosure, the cutting portion CP can be any one of the M numbers undercut portions UC. For example, as shown in FIG. 3, the undercut portions UC can be formed on both side of the planarization layer 113' disposed on the transmissive portion TA. The planarization layer 113' disposed in the transmissive area TA is disposed in the shape of an island spaced apart from the planarization layer 113 disposed in the light emission EA, and can therefore be expressed in terms of an island OC or first planarization layer. In contrast, the planarization layer 113 disposed to overlap the light emission area EA (and/or the non-light emission area NEA) is disposed to cover the thin-film transistor 112 thus can therefore be expressed in terms of a capping OC or second planarization layer.

For example, as shown in FIG. 2, two of the planarization layer 113' (or first planarization layer 113') disposed on the transmissive area TA can be in parallel to the first direction (Y-axis direction) on the transmissive area TA. In this case, one transmissive area TA can have four undercut portions UC disposed therein, as shown in FIG. 3. Any one of these four undercut portions UC can be the cutting portion CP. However, it is not necessary to be limited thereto, and the cutting portion CP can be formed in the light emission area EA or the transmissive area TA rather than in the undercut portions UC. Furthermore, the cutting portion CP can be disposed in an area that is not a dam area DMA, and may not be disposed in an area where the fill member RF is disposed. This is because in case that the cutting portion CP is disposed in the area where the filling member RF is disposed, moisture permeation can occur through the organic layer, such as the organic light emitting layer, when cut by the cutting device. Therefore, in the transparent display apparatus 100 according to one embodiment of the present disclosure, the cutting portion CP can be disposed in at least one of the undercut portions UC in an area where the filling member RF is not disposed, the light emission area EA in an area where the filling member RF is not disposed, and the transmission area TA in an area where the filling member RF is not disposed. Hereinafter, a case in which the undercut potion UC is the cutting portion CP will be described as an example.

The transparent display apparatus 100 according to one embodiment of the present disclosure can be implemented as a plurality of transparent display apparatuses having different areas or the same area when any one of the M numbers undercut portions UC is cut by a cutting device. Since the organic light-emitting layer 116 is discontinuous at the undercut portions UC, moisture permeation through the organic light-emitting layer 116 can be prevented even when the transparent display apparatus 100 is cut by the cutting device. Furthermore, since the cutting portion CP is disposed between the plurality of dam areas DMAs, in the edges of each transparent display apparatus (e.g., the first transparent display apparatus 101 and the second transparent display apparatus 102), a structure in which the dam areas DMAs surround the display area DA can be provided even when the transparent display apparatus 100 is cut by the cutting device. Further, in each of the transparent display apparatuses (e.g., the first transparent display apparatus 101 and the second transparent display apparatus 102), the getter included in the connecting members RD disposed at the edges can be capable of absorbing moisture and oxygen, thereby further maximizing the prevention of moisture penetration to the display area DA.

Referring to FIG. 3, in the transparent display apparatus 100 according to one embodiment of the present disclosure, the organic light emitting layer 116 can be discontinuous at the undercut portion UC. In addition, each of the cathode electrode 117 and the encapsulation layer 118 can also be discontinuous at the undercut portion UC. Thus, as shown in FIG. 3, the first planarization layer 113', the organic light emitting layer 116 disposed on the first planarization layer 113', the cathode electrode 117, and the encapsulation layer 118 can be disposed to be a shape of an island. Thus, on both sides of the first planarization layer 113', the connecting members RD can be disposed up to the undercut portion UC. The transparent display apparatus 100 according to one embodiment of the present disclosure can be further prevented from moisture permeation because the connecting members RD including getters are disposed up to the undercut portion UC. However, it is not necessary to be limited to this, and the connecting member RD can be partially formed only on one side of the first planarization layer 113'.

On the other hand, the transparent display apparatus 100 according to one embodiment of the present disclosure can be configured that various types (or various sizes) of the transparent display apparatus can be manufactured without an additional masking process through the process of forming the undercut portion UC that disconnects the organic emitting layer 116, thus production energy can be reduced compared to the case of manufacturing various types (or various sizes) of the transparent display apparatus through various processes.

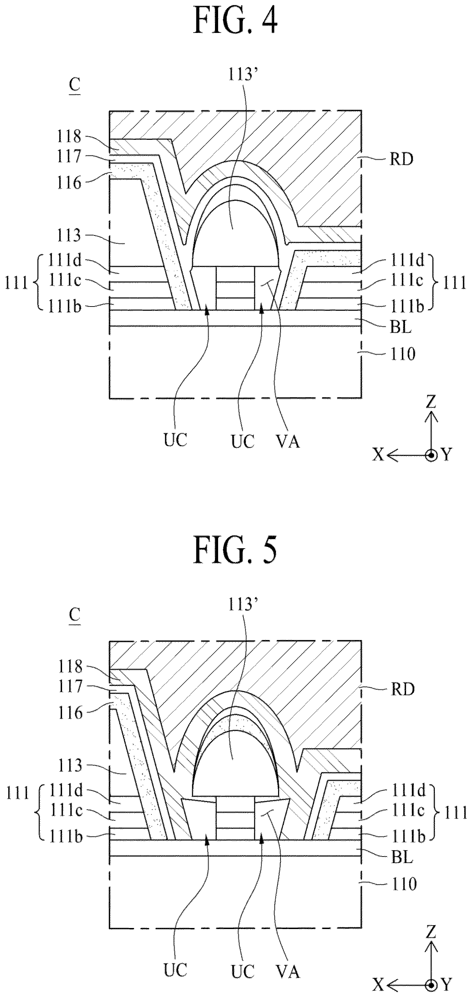

FIG. 4 is a schematic cross-sectional view of another example of portion C shown in FIG. 3.

Referring to FIG. 4, in the transparent display apparatus 100 according to one embodiment of the present disclosure, the organic light emitting layer 116 can be discontinuous at the undercut portion UC, and each of the cathode electrode 117 and the encapsulation layer 118 can be continuous at the undercut portion UC. This can be implemented by forming a width of the undercut portion UC to become narrow compared to the undercut portion UC of FIG. 3. Here, the width of the undercut portion UC can refer to a length in the second direction (X-axis direction) of the upper surface of the buffer layer BL adjacent to the undercut portion UC with reference to FIG. 4. Accordingly, the transparent display apparatus 100 according to FIG. 4 can be provided with a structure in which the organic light emitting layer 116 is discontinuous at the undercut portion UC, and each of the cathode electrode 117 and the encapsulation layer 118 is continuous.

On the other hand, since the undercut portion UC is formed, and then the organic light emitting layer 116, the cathode electrode 117, and the encapsulation layer 118 are sequentially deposited under vacuum, the undercut portion UC can partially include a vacuum area VA. As shown in FIG. 4, the vacuum region VA can be sealed by the buffer layer BL and the cathode electrode 117 and the first planarization layer 113'.

FIG. 5 is a schematic cross-sectional view illustrating another example of portion C shown in FIG. 3.

Referring to FIG. 5, in the transparent display apparatus 100 according to one embodiment of the present disclosure, each of the organic light emitting layer 116 and the cathode electrode 117 can be discontinuous at the undercut portion UC, and the encapsulation layer 118 can be continuous at the undercut portion UC. This can be implemented by forming a width of the undercut portion UC to become narrow compared to the undercut portion UC of FIG. 3 and to become wide compared to the undercut portion UC of FIG. 4. Here, the width of the undercut portion UC can mean a length in the second direction (X-axis direction) of the upper surface of the buffer layer BL adjacent to the undercut portion UC with reference to FIG. 5. Accordingly, the transparent display apparatus 100 according to FIG. 5 can be provided with a structure in which each of the organic light emitting layer 116 and the cathode electrode 117 is discontinuous at the undercut portion UC, and the encapsulation layer 118 is continuous at the undercut portion UC.

On the other hand, since the undercut portion UC is formed, and then the organic light emitting layer 116, the cathode electrode 117, and the encapsulation layer 118 are sequentially deposited under vacuum, the undercut portion UC can partially include a vacuum area VA. As shown in FIG. 5, the vacuum area VA can be sealed by the buffer layer BL and the encapsulation layer 118.

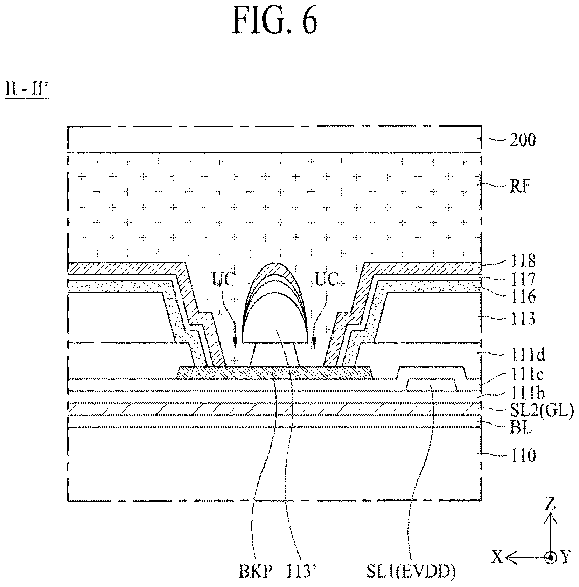

FIG. 6 is a schematic cross-sectional view of line II - II' shown in FIG. 2.

Referring to FIG. 2 and FIG. 6, in the transparent display apparatus 100 according to one embodiment of the present disclosure, the undercut portion UC can include a blocking portion BKP that partially overlaps the planarization layer 113' (or the first planarization layer 113') between the first passivation layer 111c and the second passivation layer 111d. For example, the blocking portion BKP can be formed at the intersection of the first planarization layer 113' and the second line SL2 (or gate line GL), as shown in FIG. 2.

The blocking portion BKP is to prevent all of inorganic layers disposed on upper of the wiring (e.g., the second line SL2 (or gate line GL)) from being etched by the etchant used when the undercut portion UC is formed. Therefore, as shown in FIG. 6, the blocking portion BKP is disposed on inorganic layer (or the interlayer insulating layer 111b and the first passivation layer 111c) on the second line SL2 (or the gate line GL) thus inorganic layer (or the interlayer insulating layer 111b and the first passivation layer 111c) is protected from the etching solution. Accordingly, contact between the second line SL2 (or gate line GL) and the cathode electrode 117 can be prevented when the cathode electrode 117 is deposited. The blocking portion BKP according to one example can comprise a metallic material with high resistance to the etchant. The blocking portion BKP can be formed in the same layer as the connecting electrode CE.

Referring to FIG. 6, the blocking portion BKP can be provided to have a wider width than the undercut portion UC in the second direction (X-axis direction). Thus, the edge of the blocking portion BKP can be covered by the second passivation layer 111d. The organic light emitting layer 116 and the cathode electrode 117 and the encapsulation layer 118, each of which is discontinuous by the undercut portion UC, can be in contact with the upper surface of the blocking portion BKP.

On the other hand, as shown in FIG. 6, the filling member RF used for bonding the first substrate 110 and the second substrate 200 can be disposed on the upper side of the encapsulation layer 118 and the upper side of the blocking portion BKP.

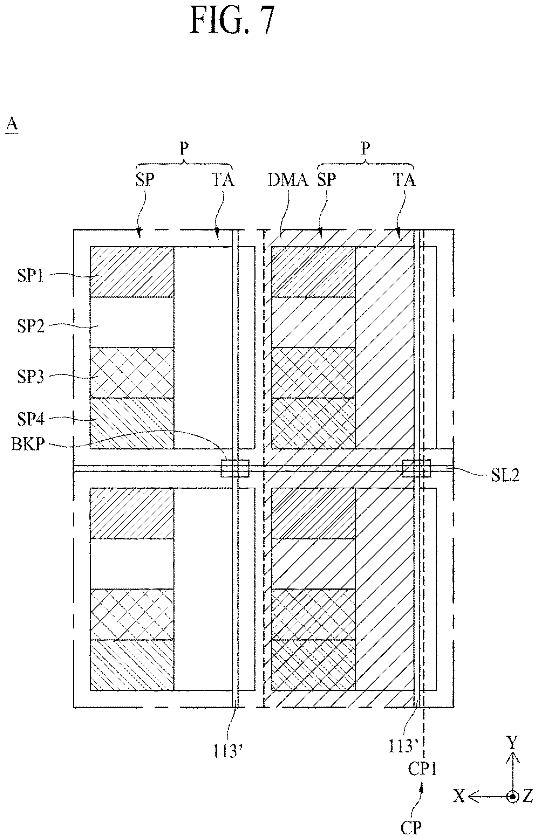

FIG 7 is a schematic plan view of another example of FIG 2.

The transparent display apparatus 100 according to FIG. 2 has two first planarization layers 113' extended in the first direction (Y-axis direction) in the transmissive portion TA. Accordingly, the transparent display apparatus 100 according to FIG. 2 can be provided with four undercut portions UC extended in a first direction (Y-axis direction) along an edge of each of the two first planarization layers 113'. Therefore, the transparent display apparatus 100 according to FIG. 2 can be provided with undercut portions UC (or cutting portions CP) that can be cut by a cutting device at various locations, thus a transparent display apparatus having an area (or size) that meets various needs of a user can be easily manufactured.

In contrast, the transparent display apparatus 100 according to FIG. 7 has one first planarization layer 113' disposed to be extended in the first direction (Y-axis direction) in the transmissive portion TA. Therefore, the transparent display apparatus 100 according to FIG. 7 can be provided with two undercut portions UC disposed in the first direction (Y-axis direction) along the edge of each of the first planarization layers 113'. The transparent display apparatus 100 according to FIG. 7 can be more durable against external impacts since the number of undercut portions UC disposed in the transmissive portion TA is small. In FIG. 7, one first planarization layer 113' is shown disposed on one pixel P, but it is not limited thereto, and one first planarization layer 113' can be disposed on every two pixels P.

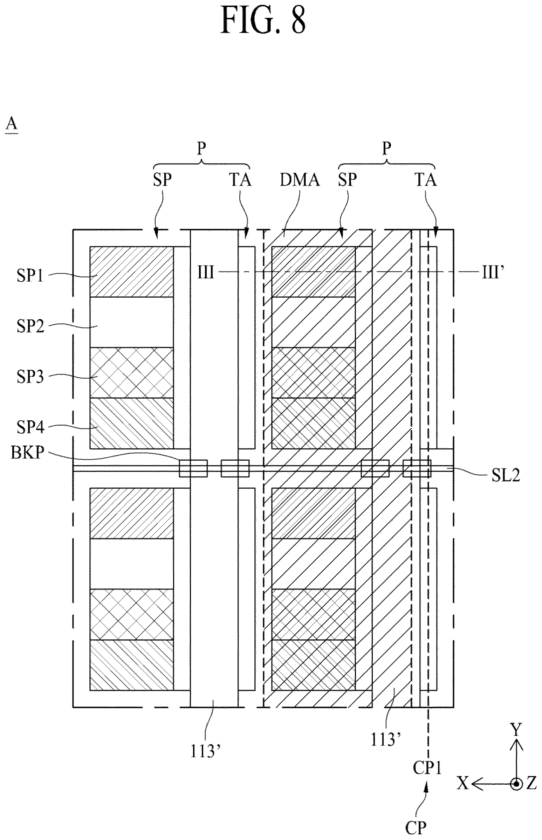

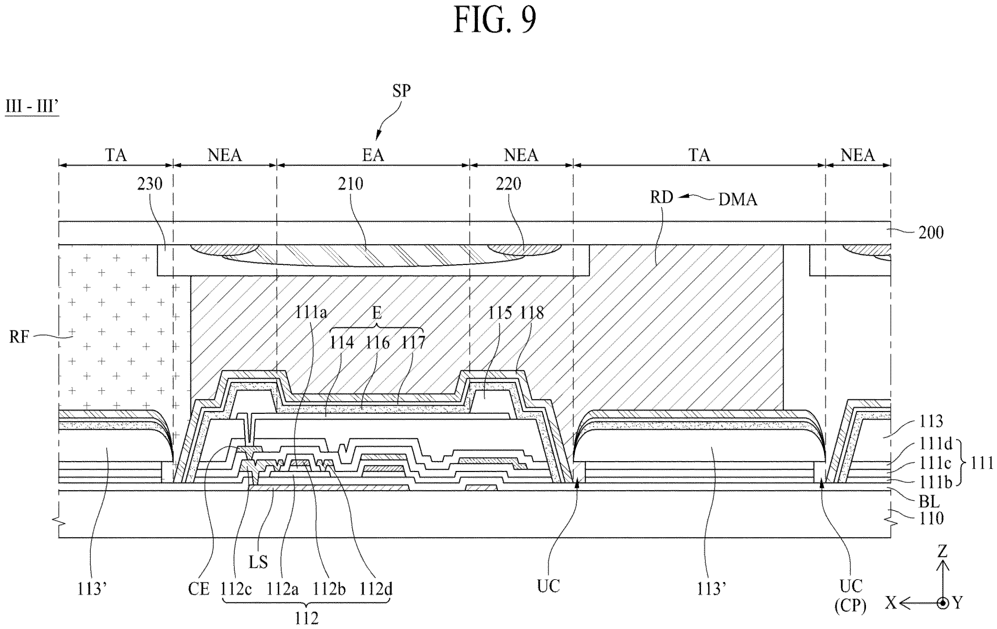

FIG. 8 is a schematic plan view illustrating another example of FIG. 2, and FIG. 9 is a schematic cross-sectional view of line III-III' shown in FIG. 8.

The transparent display apparatus 100 according to FIG. 8 has one first planarization layer 113' extended in the first direction (Y-axis direction) from the transmitting portion TA. However, unlike the transparent display apparatus 100 according to FIG. 2, in the transparent display apparatus 100 according to FIG. 8, the first planarization layer 113' is provided with a wider width of in the second direction (X-axis direction). Therefore, the transparent display apparatus 100 according to FIG. 8 can be maximally durable against external impact, as the one first planarization 113' is disposed in the transmission part TA in a wider width in the second direction (X-axis direction), as shown in FIG. 9.

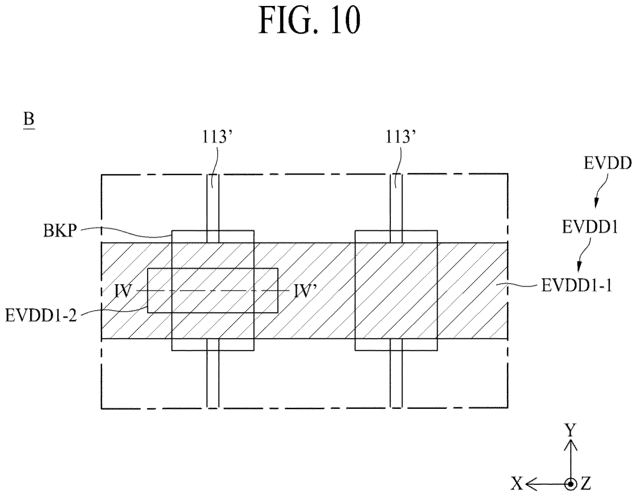

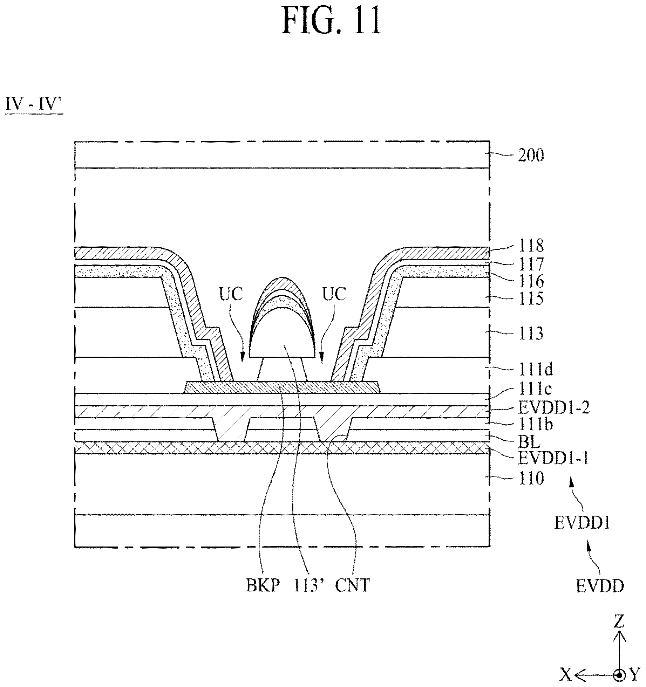

FIG. 10 is an enlarged plan view of portion B shown in FIG. 1, and FIG. 11 is a schematic cross-sectional view of line IV-IV' shown in FIG. 10.

Referring to FIG. 10, in the transparent display apparatus 100 according to one embodiment of the present disclosure, the first substrate 110 can include a pixel power shorting bar EVDD disposed in the second direction (X-axis direction) in the non-display area NDA.

For example, the pixel power shorting bar EVDD can include a first pixel power shorting bar EVDD1 disposed in a first non-display area NDA1, the first pixel power shorting bar EVDD1 includes a first sub-pixel power shorting bar EVDD1-1, which is extended in the second direction (X-axis direction), and a second sub-pixel power shorting bar EVDD1-2, which is disposed on the first sub-pixel power shorting bar EVDD1-1 and smaller than the first sub- pixel power shorting bar EVDD1-1 in size. As illustrated in FIG. 10, each of the first sub-pixel power shorting bar EVDD1-1 and the second sub-pixel power shorting bar EVDD1-2 can intersect the first planarization layer 113' in the first non-display area NDA1.

Referring to FIG. 11, the first sub-pixel power shorting bar EVDD1-1 can be disposed between the first substrate 110 and the buffer layer BL. The second sub-pixel power shorting bar EVDD1-2 can be disposed between the interlayer insulating layer 111b and the first passivation layer 111c, and can be connected to the first sub-pixel power shorting bar EVDD1-1 through a contact hole CNT.

The blocking portion BKP can be disposed on the pixel power shorting bar EVDD. Thus, the blocking portion BKP can protect the pixel power shorting bar EVDD (or the second sub-pixel power shorting bar EVDD1-2) from the etchant used when the undercut portion UC is formed. The blocking portion BKP according to one example can comprise a metallic material having high resistance to the etchant, and can be formed in the same layer as the connecting electrode CE.

The blocking portion BKP can be provided to have a wider width than the undercut portion UC in the second direction (X-axis direction). Thus, the edge of the blocking portion BKP can be covered by the second passivation layer 111d. Each of the organic light emitting layer 116, the cathode electrode 117, and the encapsulation layer 118, which is discontinuous by the undercut portion UC, can be in contact with the upper surface of the blocking portion BKP, respectively. On the other hand, since FIG. 11 is a cross-sectional view of the first non-display area NDA1, unlike FIG. 6, the bank 115 can be disposed on the planarization layer 113 (or the second planarization layer 113).

FIG. 12 is a schematic cross-sectional view of a transparent display apparatus according to a second embodiment of the present disclosure.

Referring to FIG. 12, the transparent display apparatus 100 according to the second embodiment of the present disclosure is identical to the transparent display apparatus according to FIG. 1 mentioned above, except that the second substrate 200 (or an opposing substrate) further comprises an upper inorganic layer 240 disposed to cover the plurality of upper organic layers 230. Accordingly, the same drawing symbols have been assigned to the same configuration, and only the different configurations will be described below.

In the case of the transparent display apparatus according to FIG. 1 mentioned above, since the plurality of upper organic layers 230 are disposed spaced apart from each other on the second substrate 200, moisture permeation through the upper organic layers 230 can be prevented. Furthermore, due to the plurality of upper organic layers 230 disposed spaced apart from each other on the second substrate 200, the overflow in the direction D1 from the connecting member RD toward the filling member RF and/or in the opposite direction D2 (or in the direction D2 toward an area without both the filling member RF and the connecting member RD) can be reduced or prevented, when the first substrate 110 and the second substrate 200 are bonded. For example, the direction D2 toward an area where there is neither the filling member RF nor the connecting member RD can be the direction toward an area where the cutting portion CP is disposed. For example, the area where there is neither the filling member RF nor the connecting member RD can be the area of the third transparent display apparatus 103 where the cutting portion CP is disposed in FIG. 1.

In contrast, in the case of the transparent display apparatus according to FIG. 12, the upper inorganic layer 240 can be disposed to cover the plurality of upper organic layers 230 disposed to be spaced apart from each other. Thus, the upper inorganic layer 240 can be in contact with the second substrate 200 between the plurality of upper organic layers 230. Since the upper inorganic layer 240 is in contact with the second substrate 200 between the plurality of upper organic layers 230, moisture permeation prevention through the plurality of upper organic layers 230 can be maximized.

Furthermore, in the case of the transparent display apparatus according to FIG. 12, since the upper inorganic layer 240 contacts the second substrate 200 between the plurality of upper organic layers 230, the upper inorganic layer 240 can be disposed in the shape of a groove (or trench) between the plurality of upper organic layers 230. Here, the groove (or trench) can be in the shape of a concave depression in the first substrate 110 in a direction toward the second substrate 200. Thus, in the transparent display apparatus 100 according to FIG. 12, due to the upper inorganic layer 240 disposed in the shape of a groove, the overflow in the direction D1 from the connecting member RD toward the filling member RF and/or in the opposite direction D2 (or in the direction D2 toward an area there is neither the filling member RF nor the connecting member RD) can be reduced or prevented when the first substrate 110 and the second substrate 200 are bonded.

Meanwhile, since FIG. 12 is a cross-sectional view in the second direction (X-axis direction) from FIG. 2, the sub-pixels SPs (or first sub-pixel SP1) emitting the same color can be disposed adjacent in the second direction (X-axis direction).

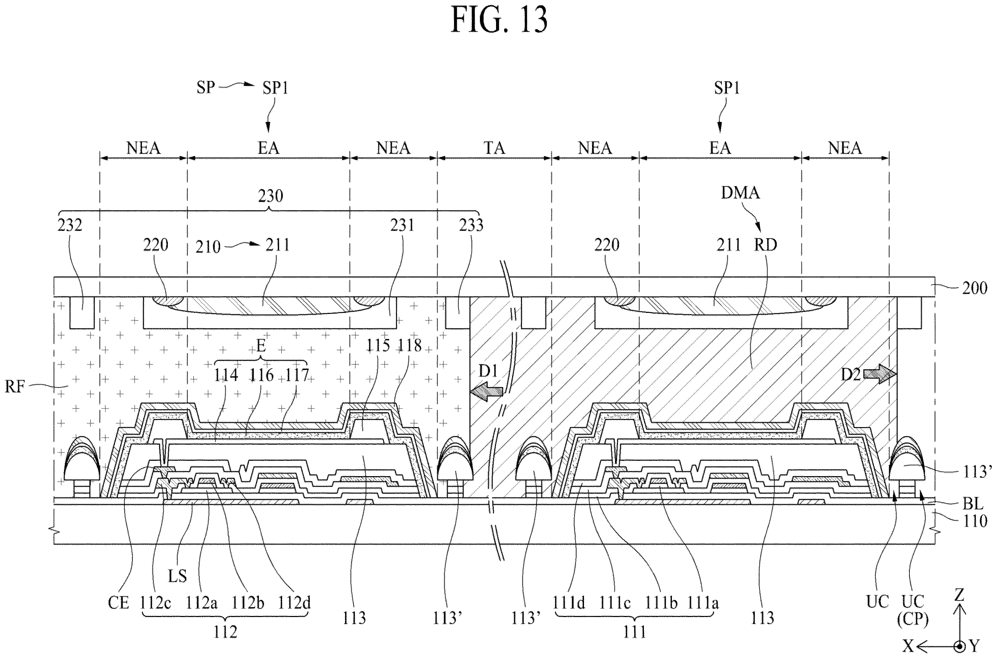

FIG. 13 is a schematic cross-sectional view of a transparent display apparatus according to a third embodiment of the present disclosure.

Referring now to FIG. 13, the transparent display apparatus 100 according to the third embodiment of the present disclosure is identical to the transparent display apparatus according to FIG. 1 mentioned above, except that the structure of each of the plurality of upper organic layers 230 provided on the second substrate 200 (or opposite substrate) has been changed. Accordingly, the same drawing symbols have been assigned to the same configuration, and only the different configurations will be described hereinafter.

In the case of the transparent display apparatus according to FIG. 1 mentioned above, since the plurality of upper organic layers 230 are disposed to be spaced apart from each other on the second substrate 200, moisture permeation through the upper organic layers can be prevented. Furthermore, due to the plurality of upper organic layers 230 spaced apart from each other on the second substrate 200, the overflow in the direction D1 from the connecting member RD toward the filling member RF and/or in the opposite direction D2 (or the direction D2 toward an area where there is neither the filling member RF nor the connecting member RD) can be reduced or prevented when the first substrate 110 and the second substrate 200 are bonded.

In contrast, in the case of the transparent display apparatus according to FIG. 13, each of the plurality of upper organic layers 230 can include a main organic layer 231 disposed correspondingly to each of the plurality of sub-pixels SPs (or the plurality of light emission areas EA), and a plurality of sub-organic layers 232, 233 disposed spaced apart from the main organic layer 231. Thus, the connecting member RD can be disposed between the main organic layer 231 and the plurality of sub-organic layers 232, 233. Further, as shown in FIG. 13, the connecting member RD can also be disposed between the sub-organic layers of each of two adjacent sub-pixels. Thus, since the transparent display apparatus 100 according to FIG. 13 can be provided with more grooves

(or trenches) formed between the main organic layer 231 and the plurality of sub-organic layers 232, 233 compared to the transparent display apparatus according to FIG. 1, when the first substrate 110 and the second substrate 200 are bonded, the flow in the direction D1 from the connecting member RD toward the filling member RF and/or in the opposite direction D2 (or the direction D2 toward an area where there is neither the filling member RF nor the connecting member RD) can be further reduced or prevented.

On the other hand, the transparent display apparatus 100 according to FIG. 13 can have the plurality of sub-organic layers 232, 233 overlapping the transmissive portion TA in the third direction (Z-axis direction). For example, each of the plurality of sub-organic layers 232, 233 can be disposed to correspond to each of the plurality of planarization layers 113' (or first planarization layer 113') disposed in the transmissive portion TA. Thus, since the transparent display apparatus 100 according to FIG. 13 has a smaller cell gap (or gap between the plurality of sub-organic layers 232, 233 and the plurality of first planarization layers 113') in the transmissive portion TA compared to the transparent display apparatus according to FIG. 1, the prevention of overflow of the connecting member RD to the filling member RF (or to the void space without the filling member RF and the connecting member RD) can be maximized when the first substrate 110 and the second substrate 200 are bonded.

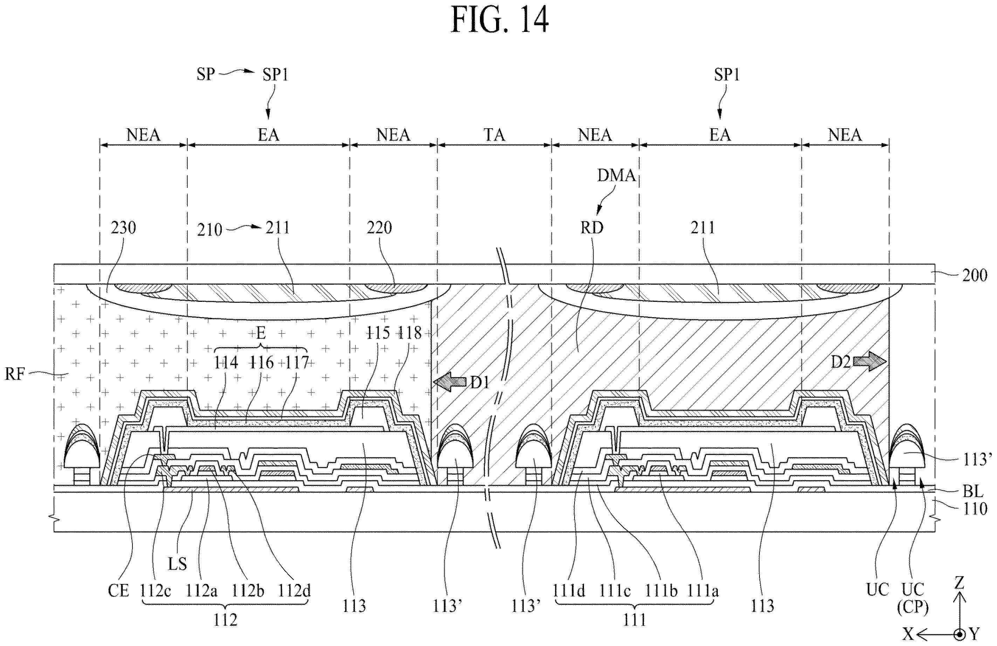

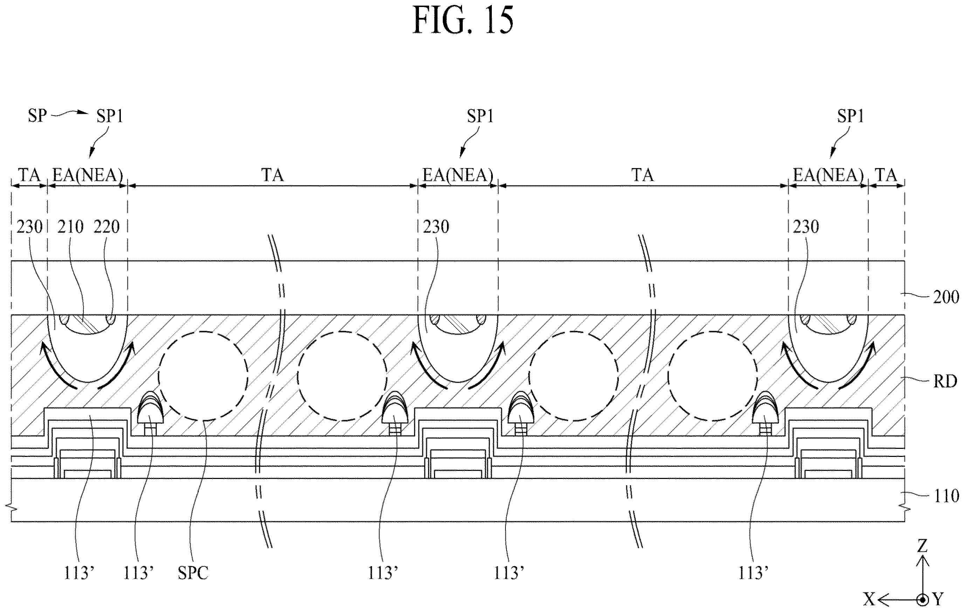

FIG. 14 is a schematic cross-sectional view of a transparent display apparatus according to a fourth embodiment of the present disclosure, and FIG. 15 is a schematic cross-sectional view of FIG. 14.

Referring to FIG. 14 and FIG. 15, the transparent display apparatus 100 according to the fourth embodiment of the present disclosure is identical to the transparent display apparatus according to FIG. 1 mentioned above, except that the shape of each of the plurality of upper organic layers 230 provided on the second substrate 200 (or opposite substrate) has been changed. Accordingly, the same drawing symbols have been assigned to the same configuration, and only the different configurations will be described hereinafter.

In the case of the transparent display apparatus according to FIG. 1, the plurality of upper organic layers 230 are disposed spaced apart from each other on the second substrate 200, and each of the plurality of upper organic layers 230 is provided in a square shape. Accordingly, in the transparent display apparatus according to FIG. 1, due to the plurality of upper organic layers 230 having a square shape, the overflow in the direction D1 from the connecting member RD toward the filling member RF and/or in the opposite direction D2 (or in the direction D2 toward an area where there is neither the filling member RF nor the connecting member RD) can be reduced or prevented when the first substrate 110 and the second substrate 200 are bonded.

In contrast, in the case of the transparent display apparatus according to FIG. 14, a width of each of the plurality of upper organic layers 230 can be formed to become narrow from the second substrate 200 toward the first substrate 110. For example, each of the plurality of upper organic layers 230 can be configured to have a convex lens shape (or parabolic shape) or a round shape in a direction from the second substrate 200 toward the first substrate 110. Thus, in the transparent display apparatus 100 according to FIG. 14, due to the plurality of upper organic layers 230 having a lens shape, the overflow in the direction D1 from the connecting member RD towards the filling member RF and/or in the opposite direction D2 (or in the direction D2 toward an area where there is neither the filling member RF nor the connecting member RD) can be reduced or prevented when the first substrate 110 and the second substrate 200 are bonded.

On the other hand, in the transparent display apparatus 100 according to the fourth embodiment of the present disclosure, since a width of each of the plurality of upper organic layers 230 is formed to become narrow from the second substrate 200 toward the first substrate 110, when the first substrate 110 and the second substrate 200 are bonded, a spacer SPC disposed between the second substrate 200 and the first substrate 110 may not be disposed to overlap the light emission area EA, and can be disposed between the plurality of upper organic layers 230. For example, the spacer SPC can be pushed between the upper organic layers 230 due to the rounded shape of the upper organic layers 230 when the first substrate 110 and the second substrate 200 are bonded. Therefore, in the transparent display apparatus 100 according to the fourth embodiment of the present disclosure, since the spacers SPC are disposed between the plurality of upper organic layers 230 (or in the transmissive area TA), the cell gap can become a smaller than the case where the spacers are disposed to overlap the light emission area EA, thus light viewing angle characteristics can be improved.

Furthermore, in the transparent display apparatus 100 according to the fourth embodiment of the present disclosure, since the spacer SPC is disposed between the plurality of upper organic layers 230, the cell gap becomes smaller than in the case where the spacer is disposed to overlap the light emission area EA, and thus, color mixing between the plurality of sub-pixels SPs can be prevented.

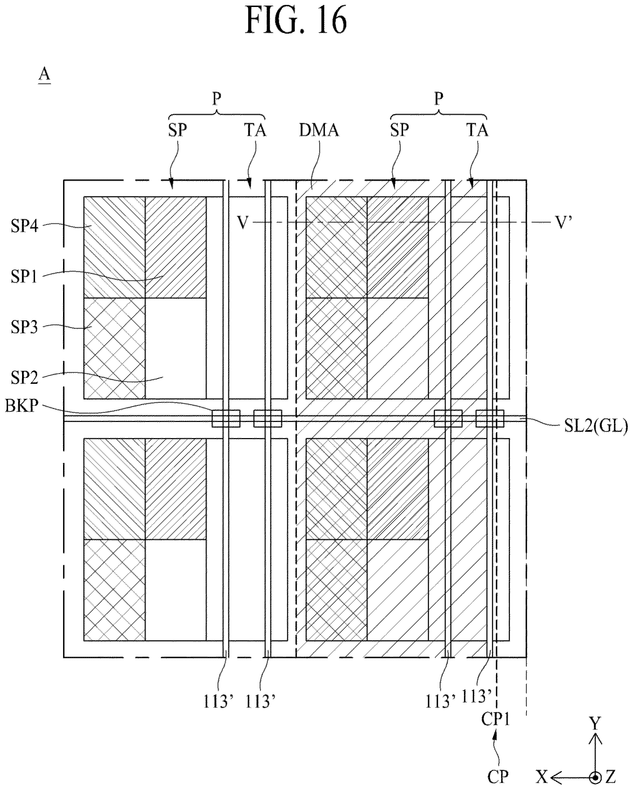

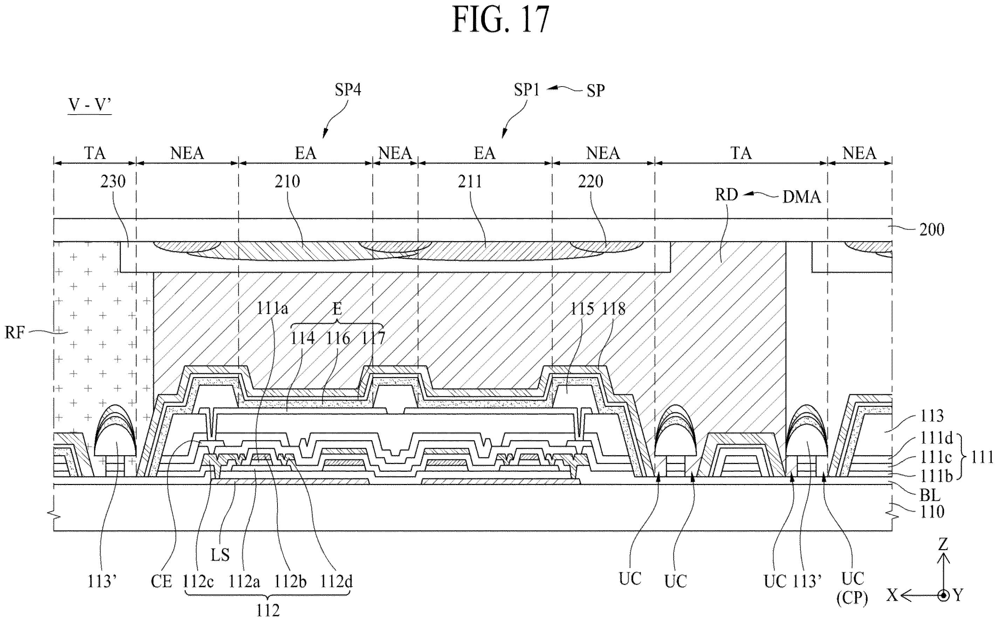

FIG. 16 is a schematic cross-sectional view illustrating a portion of a transparent display apparatus according to a fifth embodiment of the present disclosure, and FIG. 17 is a schematic cross-sectional view of line V-V' shown in FIG. 16.

The transparent display apparatus 100 according to the fifth embodiment of the present disclosure is identical to the transparent display apparatus according to FIG. 1 mentioned above, except that the layout structure of the plurality of sub-pixels SPs included in the pixels P has been changed. Therefore, the same drawing symbols have been assigned to the same configuration, and only the different configurations will be described hereinafter.

In the transparent display apparatus according to FIG. 1 mentioned above, the plurality of sub-pixels SPs included in each of the plurality of pixels P are disposed in the shape of a long stripe in the first direction (Y-axis direction). For example, the first sub-pixel SP1 emitting red light, a second sub-pixel SP2 emitting white light, a third sub-pixel SP3 emitting green light, and a fourth sub-pixel SP4 emitting blue light are disposed to be extended in the first direction (Y-axis direction), and each of the first to fourth sub-pixels SP1, SP2, SP3, SP4 is disposed adjacent to the transmission area TA in the second direction (X-axis direction).

In contrast, in the case of the transparent display apparatus according to FIG. 16, the first sub-pixel SP1 emitting red light, the second sub-pixel SP2 emitting white light, the third sub-pixel SP3 emitting green light, and the fourth sub-pixel SP4 emitting blue light can be provided in a 2 X 2 structure. For example, the fourth sub-pixel SP4 emitting blue light and the first sub-pixel SP1 emitting red light can be disposed adjacent to each other in the second direction (X-axis direction), and the third sub-pixel SP3 emitting green light and the second sub-pixel SP2 emitting white light can be disposed adjacent to each other in the second direction (X-axis direction). Here, the third sub-pixel SP3 and the second sub-pixel SP2 can be disposed adjacent to the fourth sub-pixel SP4 and the first sub-pixel SP1 in the first direction (Y-axis direction). Further, the transmission area TA can be disposed adjacent to the right side of the first sub-pixel SP1 and the second sub-pixel SP2. However, the layout structure of the first to fourth sub-pixels SP1, SP2, SP3, SP4 can be changed depending on the design of the first substrate 110 (or the second substrate 200).

Thus, as shown in FIG. 17, the transparent display apparatus 100 according to the fifth embodiment of the present disclosure can be provided with a structure in which the color filters 210, 211 of each of the two different sub-pixels SPs are covered by one upper organic layer 230.

Embodiments of the present disclosure have been described in more detail with reference to the accompanying drawings, but the present disclosure is not necessarily limited to these embodiments and can be implemented in various modifications without departing from the technical ideas of the present disclosure. Accordingly, the embodiments disclosed herein are intended to illustrate and not to limit the technical ideas of the present disclosure, and the scope of the technical ideas of the present disclosure is not limited by these embodiments. Therefore, the embodiments described above are exemplary in all respects and should be understood as non-limiting. The scope of protection of this disclosure shall be construed by the claims, and all technical ideas within the scope of the claims shall be construed to be included within the scope of the claims.

The present disclosure includes the plurality of dam areas to allow the display panel to be cut into various sizes, so that it can be manufactured in various types (or different sizes).

Furthermore, the present disclosure can be manufactured in various types (or different sizes) without additional masking processes, which can result in reduced production energy compared to transparent display apparatuses produced in various types through different production processes.

Furthermore, the present disclosure is provided that the moisture permeation path of the cutting portion is discontinuous, thus moisture permeation can be reduced or prevented even when the product is manufactured in various types (or various sizes).

The effects that can be obtained from the present disclosure are not limited to those mentioned above, and other effects not mentioned will be apparent to one having ordinary skill in the art from the above description.

## Claims

1. A transparent display apparatus comprising:
a substrate including a display area in which a plurality of pixels are disposed and a non-display area adjacent to the display area, the plurality of pixels having a transmissive portion and a plurality of sub-pixels; and
a plurality of dam areas extending from the non-display area to the display area on the substrate, and provided to be a closed loop.

2. The transparent display apparatus of claim 1, wherein each of the plurality of dam areas is provided in N numbers on the substrate, where N is an integer greater than 1, and optionally wherein the transparent display apparatus further comprises a cutting portion provided between the N dam areas,
and further optionally wherein the substrate further comprises a plurality of gate drivers disposed in a first direction in the non-display area, and wherein the cutting portion is disposed in parallel to the plurality of gate drivers.

3. The transparent display apparatus of claim 1 or 2, further comprising:
a planarization layer disposed on the substrate; and
a plurality of inorganic layers disposed between the substrate and the planarization layer,
wherein the transmissive portion includes an undercut portion where the planarization layer and the plurality of inorganic layers are partially removed.

4. The transparent display apparatus of claim 3,
wherein the undercut portion is provided in M numbers, where M is an integer greater than 0, and optionally further comprising a cutting portion provided between the plurality of dam areas,
wherein the cutting portion is any one of the M undercut portions.

5. The transparent display apparatus of claim 3 or 4,
wherein the plurality of inorganic layers comprise a first passivation layer disposed between the substrate and the planarization layer, and a second passivation layer disposed between the first passivation layer and the planarization layer, and
wherein the undercut portion includes a blocking portion partially overlapping the planarization layer between the first passivation layer and the second passivation layer, and optionally wherein:
the substrate further comprises a gate line extending in a second direction in the display area, and the blocking portion is disposed on the gate line, and/or
the substrate further comprises a pixel power shorting bar disposed in a second direction in the non-display area, and the blocking portion is disposed on the pixel power shorting bar.

6. The transparent display apparatus of any preceding claim, further comprising:
an opposing substrate disposed to face the substrate; and
a plurality of upper organic layers covering color filters disposed to correspond to each of the plurality of sub-pixels on the opposing substrate,
wherein the plurality of upper organic layers are disposed to be spaced apart from each other with the transmissive portion interposed therebetween.

7. The transparent display apparatus of claim 6,
wherein each of the plurality of dam areas comprises a connecting member disposed between the substrate and the opposing substrate, and wherein the connecting member is partially disposed between the plurality of upper organic layers, and/or
wherein the opposing substrate comprises an upper inorganic layer disposed to cover the plurality of upper organic layers, and wherein the upper inorganic layer contacts the opposing substrate between the plurality of upper organic layers.

8. The transparent display apparatus of claim 7,
wherein each of the plurality of upper organic layers comprises:
a main organic layer disposed to correspond to each of the plurality of sub-pixels, and
a plurality of sub-organic layers disposed to be spaced apart from the main organic layer, and
wherein the connecting member is disposed between the main organic layer and the plurality of sub-organic layers, and optionally
wherein the plurality of sub-organic layers are disposed to overlap the transmissive portion.

9. The transparent display apparatus of any of claims 6 to 8, wherein a width of each of the plurality of upper organic layers becomes narrower from the opposing substrate to the substrate, and optionally
further comprising a spacer disposed between the opposing substrate and the substrate,
wherein the spacer is disposed between the plurality of upper organic layers.

10. The transparent display apparatus of any of claims 3 to 9,
wherein each of the plurality of pixels comprises:
an anode electrode disposed on the planarization layer;
an organic light emitting layer disposed on the anode electrode;
a cathode electrode disposed on the organic light emitting layer; and
an encapsulation layer disposed on the cathode electrode, and
wherein the organic light emitting layer is discontinuous at the undercut portion, and optionally:
wherein each of the cathode electrode and the encapsulation layer is continuous at the undercut portion, and/or
wherein the cathode electrode is discontinuous at the undercut portion, and wherein the encapsulation layer is continuous at the undercut portion.

11. The transparent display apparatus of any of claims 7 to 10, further comprising a filling member which is disposed adjacent to the connecting member,
wherein the filling member is disposed to fill a gap between the substrate and the opposing substrate, so as to support the substrate and the opposing substrate, and optionally wherein:
the filling member bonds the substrate and the opposing substrate together with the connection member, and the filling member is disposed to be surrounded by the connecting member, and/or
the transparent display apparatus further comprises a cutting portion provided between the plurality of dam areas, wherein the cutting portion is disposed in at least one of undercut portions in an area where the filling member is not disposed, an area in which the pixels emit light in an area where the filling member is not disposed, and the transmission portion in an area where the filling member is not disposed.

12. The transparent display apparatus of any of claims 5 to 11, wherein the blocking portion is provided to have a wider width than the undercut portion in a second direction.

13. The transparent display apparatus of any of claims 10 to 12, further comprising:
a blocking portion disposed on the plurality of inorganic layers; and
a filling member disposed on an upper side of the encapsulation layer and an upper side of the blocking portion.

14. The transparent display apparatus of any of claims 7 to 13, further comprising a filling member which is partially disposed between the plurality of upper organic layers in the display area where the dam area is not disposed.

15. The transparent display apparatus of any of claims 8 to 14, wherein the connecting member is also disposed between the sub-organic layers of each of two adjacent sub-pixels.
